# EUROPEAN PATENT APPLICATION

(11) **EP 4 651 186 A1**
(43) Date of publication of application: **19.11.2025**
(21) Application number: 24741496.4
(22) Date of filing: 09.01.2024
(51) Int. Cl.: H01L 21/60, C09J 5/04, C09J 179/08, H01L 21/02, H01L 23/29, H01L 23/31, H01L 25/065, H01L 25/07, H01L 25/18

(54) **METHOD FOR PRODUCING MULTILAYER BODY, AND RESIN COMPOSITION**

(30) Priority: 11.01.2023 JP 2023002176
(71) Applicant: Toray Industries, Inc., Tokyo 103-8666 (JP)
(72) Inventor: ARAKI, Hitoshi, Otsu-shi, Shiga 520-8558 (JP); FUJIWARA, Takenori, Otsu-shi, Shiga 520-8558 (JP); SHOJI, Yu, Otsu-shi, Shiga 520-8558 (JP)
(74) Representative: Hoefer & Partner Patentanwälte mbB
(86) International application number: PCT/JP2024/000109
(87) International publication number: WO 2024/150723

(57) **Abstract**

The present invention addresses the problem of conventional insulating layers that are formed of SiO₂, the problem being low bonding strength. The present invention also addresses the problem of conduction failure of an electrode or reliability decrease of an obtained multilayer body in cases where a semiconductor element is bonded by means of C2W. The present invention provides a method for producing a multilayer body, the method comprising: a step (I) of preparing a first substrate which is provided, on the same surface of a substrate main body, with an exposed metal electrode (A-1) and an exposed resin layer (B-1); a step (II) of preparing a second substrate which is provided, on the same surface of a substrate main body, with an exposed metal electrode (A-2) and an exposed resin layer (B-2), or alternatively with an exposed metal electrode (A-2) and an exposed inorganic insulating layer (C); and a step (III) of bonding the first substrate and the second substrate to each other by means of direct bonding, while having at least a part of the metal electrode (A-1) and the metal electrode (A-2) face each other and having at least a part of the resin layer (B-1) and the resin layer (B-2) face each other, or alternatively having at least a part of the metal electrode (A-1) and the metal electrode (A-2) face each other and having at least a part of the resin layer (B-1) and the inorganic insulating layer (C) face each other. With respect to this method for producing a multilayer body, the resin layer (B-1) and the resin layer (B-2) each contain a specific resin.

## Description

### TECHNICAL FIELD

The present invention relates to a method for producing a laminate and a resin composition to be used for the method.

### BACKGROUND ART

Conventionally, when a chip of a semiconductor or micro electro mechanical systems (MEMS) is electrically connected to the outside, a protruding electrode (bump) of gold, copper, or the like is formed and connected to a connection substrate or the like via solder. Techniques such as underfill have been established to maintain insulation between electrodes. In recent years, as the number of electrodes connected to the outside is greatly increased and the electrode density is increased due to high integration of chips, a hybrid bonding technique in which an electrode and an insulating film are formed in the same plane without forming a bump and are connected to the outside by direct bonding has attracted attention (Patent Document 1, Non-Patent Document 1). This enables high-density mounting with an electrode pitch of 10 µm or less. Hybrid bonding includes W2W (wafer-to-wafer) by which wafers are bonded and C2W (chip-to-wafer) by which a chip and a wafer are bonded.

### PRIOR ART DOCUMENTS

### PATENT DOCUMENT

Patent Document 1: JP 2006-517344 A

### NON-PATENT DOCUMENT

Non-Patent Document 1: Y. Kagawa et al. "Novel stacked CMOS image sensor with advanced Cu2Cu hybrid bonding", 2016 IEEE International Electron Devices Meeting (IEDM), DOI: 10.1109/IEDM.2016.7838375

### SUMMARY OF THE INVENTION

### PROBLEMS TO BE SOLVED BY THE INVENTION

In hybrid bonding, SiO₂, which is a conventional insulating layer, has a problem of low bonding strength. In addition, in the case of bonding a semiconductor element by C2W, there is a problem that voids are generated due to minute foreign matters generated when a chip is diced being sandwiched in a bonding interface. As a result, in a resulting laminate, electrical continuity failure of an electrode and a decrease in reliability of the resulting laminate occurred.

### SOLUTIONS TO THE PROBLEMS

To solve the above-described problems, the present invention has the following configurations.
[1] A method for producing a laminate, the method including:
   step (I) of preparing a first substrate including an exposed (A-1) metal electrode and an exposed (B-1) resin layer provided on the same face of a substrate body;
   step (II) of preparing a second substrate including an exposed (A-2) metal electrode and an exposed (B-2) resin layer, or an exposed (A-2) metal electrode and an exposed (C) inorganic insulating layer provided on the same face of a substrate body; and
   step (III) of laminating the first substrate and the second substrate together by direct bonding,
   while making at least a part of the (A-1) metal electrode face the (A-2) metal electrode and making at least a part of the (B-1) resin layer face the (B-2) resin layer, or alternatively
   while making at least a part of the (A-1) metal electrode face the (A-2) metal electrode and making at least a part of the (B-1) resin layer face the (C) inorganic insulating layer,
   wherein at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by formula (1) or formula (2), 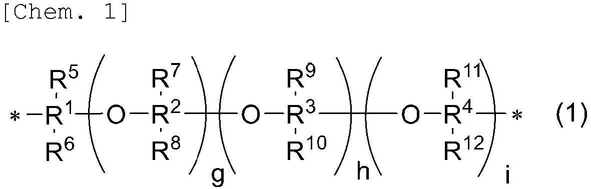
   in the formula (1), R¹ to R⁴ each independently represent an alkylene group having 1 to 6 carbon atoms; R⁵ to R¹² each independently represent a hydrogen atom, a fluorine atom, or an alkyl group having 1 to 6 carbon atoms; parenthesized structures are different from each other; g, h, and i each independently represent an integer of 0 to 35, and g + h + i > 0; symbol * represents a bonding site. 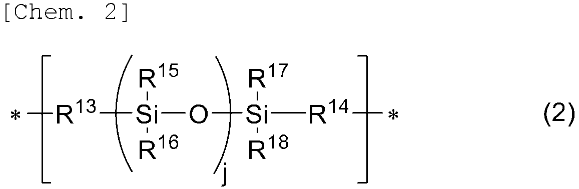
   in the formula (2), j is a natural number of 1 to 50; R¹³ and R¹⁴ each independently represent an alkylene group having 1 to 30 carbon atoms, an alkenylene group having 2 to 10 carbon atoms, an alkynylene group having 2 to 10 carbon atoms, or a phenylene group having 6 to 20 carbon atoms; R¹⁵ to R¹⁸ each independently represent an alkyl group having 1 to 30 carbon atoms, a phenyl group, or a phenoxy group; symbol * represents a bonding site.
[2] The method for producing a laminate according to [1], wherein the second substrate includes the exposed (A-2) metal electrode and the exposed (B-2) resin layer provided on the same face of a substrate body.
[3] The method for producing a laminate according to [1] or [2], wherein at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1).
[4] The method for producing a laminate according to any one of [1] to [3], wherein at least one of the (B-1) resin layer and the (B-2) resin layer contains two or more structures represented by formula (9): 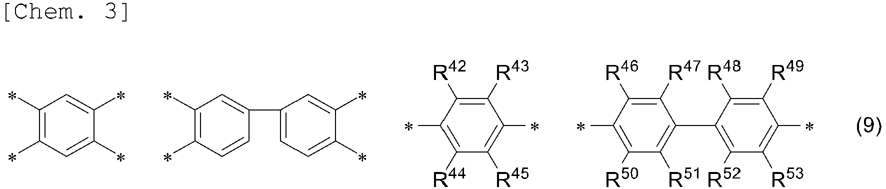 wherein sign * represents a bonding site; R⁴² to R⁵³ each independently represent a hydrogen atom, a fluorine atom, a hydroxy group, or a hydrocarbon group having 1 to 6 carbon atoms, which may be partially or fully substituted with one or more among a fluorine atom, a hydroxy group, and a carboxyl group.
[5] The method for producing a laminate according to any one of [1] to [4], wherein at least one of the (B-1) resin layer and the (B-2) resin layer further contains an antioxidant.
[6] The method for producing a laminate according to any one of [1] to [5], wherein at least one of the (B-1) resin layer and the (B-2) resin layer forms a crosslinked structure.
[7] The method for producing a laminate according to any one of [1] to [6], wherein at least one of the (B-1) resin layer and the (B-2) resin layer has an elastic modulus of 1.5 GPa or more and 7.0 GPa or less.
[8] The method for producing a laminate according to any one of [1] to [7], wherein a coefficient of thermal expansion of at least one of the (B-1) resin layer and the (B-2) resin layer in a temperature range of 50°C to 150°C is 10 ppm/K or more and 40 ppm/K or less.
[9] The method for producing a laminate according to any one of [1] to [8], wherein at least one of the step (I) and the step (II) includes a smoothing step by at least one of chemical mechanical polishing and a surface planer.
[10] The method for producing a laminate according to [2], wherein at least one of a step between the (A-1) metal electrode and the (B-1) resin layer of the first substrate after the step (I) and a step between the (A-2) metal electrode and the (B-2) resin layer of the second substrate after the step (II) is 1 nm or more and 20 nm or less, and the resin layer is lower than the metal electrode.
[11] The method for producing a laminate according to [10], wherein a step between the (A-1) metal electrode and the (B-1) resin layer of the first substrate after the step (I) is 1 nm or more and 20 nm or less, and the resin layer is lower than the metal electrode.
[12] The method for producing a laminate according to any one of [1] to [11], wherein the step (I) includes a singulation step, and in the step (III), a plurality of singulated pieces of the first substrate and a single piece of the second substrate are laminated to each other.
[13] The method for producing a laminate according to any one of [1] to [12], wherein in the step (III), at the time of laminating the first substrate and the second substrate, a temperature of a lamination stage and a temperature of a bonding head are 20°C or more and 50°C or less.
[13] The method for producing a laminate according to any one of [1] to [14], wherein a surface of each of the first substrate and the second substrate on a side to be laminated is subjected to plasma treatment as pretreatment of the step (III).
[15] The method for producing a laminate according to [14], wherein the plasma treatment is performed under an atmosphere of inert gas.
[16] The method for producing a laminate according to [15], at least helium is contained as the inert gas.
[17] The method for producing a laminate according to any one of [1] to [16], further including a step of performing annealing treatment at 150°C or more and 250°C or less after the step (III).
[18] The method for producing a laminate according to any one of [1] to [17], wherein at least one of the (B-1) resin layer and the (B-2) resin layer is formed by curing, at 170°C or more and 250°C or less, a resin composition including one or more resins which are selected from the group consisting of polyimide, polyimide precursors, polybenzoxazole, polybenzoxazole precursors, polyamide excluding the polyimide precursors and the polybenzoxazole precursors, and copolymers thereof and which have a group represented by formula (1) or formula (2), and a solvent, 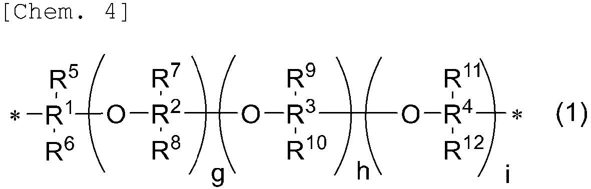 in the formula (1), R¹ to R⁴ each independently represent an alkylene group having 1 to 6 carbon atoms; R⁵ to R¹² each independently represent a hydrogen atom, a fluorine atom, or an alkyl group having 1 to 6 carbon atoms; parenthesized structures are different from each other; g, h, and i each independently represent an integer of 0 to 35, and g + h + i > 0; symbol * represents a bonding site. 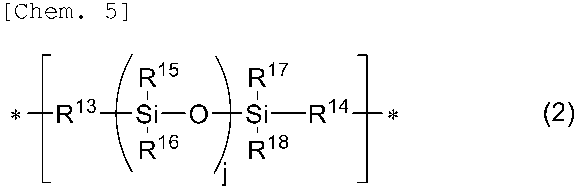 in the formula (2), j is a natural number of 1 to 50; R¹³ and R¹⁴ may be the same or different and each represent an alkylene group having 1 to 30 carbon atoms, an alkenylene group, an alkynylene group, or a phenylene group; R¹⁵ to R¹⁸ may be the same or different and each represent an alkyl group having 1 to 30 carbon atoms, a phenyl group, or a phenoxy group; symbol * represents a bonding site.
[19] A resin composition including a resin which has a group represented by the following formula (1) or the following formula (2) and which contains one or more among polyimides, polyimide precursors, polybenzoxazoles, polybenzoxazole precursors, polyamides excluding the polyimide precursors and the polybenzoxazole precursors, and copolymers thereof, and a solvent,
   the resin composition being to be used for at least one resin layer of a (B-1) resin layer and a (B-2) resin layer in a method for producing a laminate including at least the following steps (I), (II) and (III):
   step (I): preparing a first substrate including an exposed (A-1) metal electrode and an exposed (B-1) resin layer provided on the same face of a substrate body;
   step (II): preparing a second substrate including an exposed (A-2) metal electrode and an exposed (B-2) resin layer, or an exposed (A-2) metal electrode and an exposed (C) inorganic insulating layer provided on the same face of a substrate body;
   step (III): laminating the first substrate and the second substrate together by direct bonding while making at least a part of the (A-1) metal electrode and the (A-2) metal electrode face each other and making at least a part of the (B-1) resin layer and the (B-2) resin layer face each other, or alternatively making at least a part of the (A-1) metal electrode and the (A-2) metal electrode face each other and making at least a part of the (B-1) resin layer and the (C) inorganic insulating layer face each other, 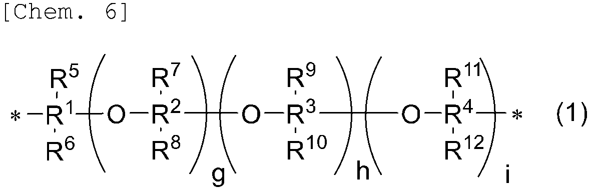 in the formula (1), R¹ to R⁴ each independently represent an alkylene group having 1 to 6 carbon atoms; R⁵ to R¹² each independently represent a hydrogen atom, a fluorine atom, or an alkyl group having 1 to 6 carbon atoms; parenthesized structures are different from each other; g, h, and i each independently represent an integer of 0 to 35, and g + h + i > 0; symbol * represents a bonding site. 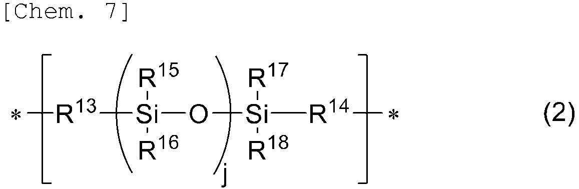 in the formula (2), j is a natural number of 1 to 50; R¹³ and R¹⁴ may be the same or different and each represent an alkylene group having 1 to 30 carbon atoms, an alkenylene group, an alkynylene group, or a phenylene group; R¹⁵ to R¹⁸ may be the same or different and each represent an alkyl group having 1 to 30 carbon atoms, a phenyl group, or a phenoxy group; symbol * represents a bonding site.
[20] The resin composition according to [19], wherein the step (III) is a step of laminating the first substrate and the second substrate together by direct bonding while making at least a part of the (A-1) metal electrode and the (A-2) metal electrode face each other and making at least a part of the (B-1) resin layer and the (B-2) resin layer face each other.
[21] The resin composition according to [19] or [20], including a resin which has a group represented by the formula (1) or the formula (2), contains two or more structures represented by formula (9), and contains one or more among polyimides, polyimide precursors, polybenzoxazoles, polybenzoxazole precursors, polyamides excluding the polyimide precursors and the polybenzoxazole precursors, and copolymers thereof, and a solvent, 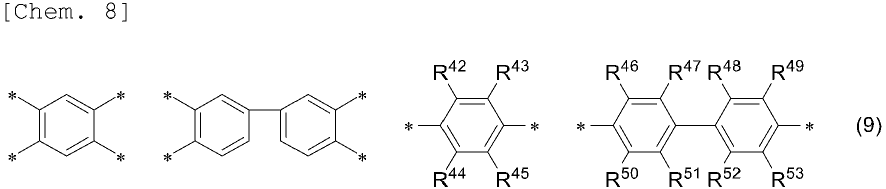 wherein sign * represents a bonding site; R⁴² to R⁵³ each independently represent a hydrogen atom, a fluorine atom, a hydroxy group, or a hydrocarbon group having 1 to 6 carbon atoms, which may be partially or fully substituted with one or more among a fluorine atom, a hydroxy group, and a carboxyl group.
[22] The resin composition according to any one of [19] to [21], further including an antioxidant.
[23] The resin composition according to any one of [19] to [22], further including a photoacid generator.
[24] The resin composition according to any one of [19] to [23], further including a crosslinking agent.

### EFFECTS OF THE INVENTION

Laminates to be obtained by the method for producing a laminate of the present invention have high bonding strength and few voids in the boding surface, and thus have high reliability. As a result of the use of the resin composition of the present invention for a resin layer of a laminate, the resulting laminates have high bonding strength and few voids in the boding surface, and thus have high reliability.

### BRIEF DESCRIPTION OF THE DRAWINGS

Fig. 1 is a sectional view of a laminate produced by W2W.
Fig. 2 is a sectional view of a laminate produced by C2W.
Fig. 3 is a process diagram of the production of a laminate by W2W.
Fig. 4 is a process diagram of the production of a laminate by C2W.
Fig. 5 is a sectional view of a substrate having formed Cu protrusion.

### EMBODIMENTS OF THE INVENTION

The method for producing a laminate of the present invention includes the following steps:
step (I) of preparing a first substrate including an exposed (A-1) metal electrode and an exposed (B-1) resin layer provided, on the same face of a substrate body;
step (II) of preparing a second substrate including an exposed (A-2) metal electrode and an exposed (B-2) resin layer, or an exposed (A-2) metal electrode and an exposed (C) inorganic insulating layer provided on the same face of a substrate body; and
step (III) of laminating the first substrate and the second substrate together by direct bonding,
while making at least a part of the (A-1) metal electrode face the (A-2) metal electrode and making at least a part of the (B-1) resin layer face the (B-2) resin layer, or alternatively
while making at least a part of the (A-1) metal electrode face the (A-2) metal electrode and making at least a part of the (B-1) resin layer face the (C) inorganic insulating layer.

In addition, at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1) or the formula (2). The resin composition of the present invention is a resin composition to be used in the production method described above.

Here, the direct bonding means that two surfaces are bonded without using any material that assists bonding, such as an adhesive. For example, while an electrically conductive bonding aid such as solder is generally used when bonding electrodes to each other, a bonding method using no bonding aid is called direct bonding. Each will be described below.

The laminate to be produced in the method for producing a laminate of the present invention uses a substrate having an (A-1) metal electrode or an (A-2) metal electrode (these two electrodes may hereinafter be collectively referred to as "(A) metal electrode"). The (A-1) metal electrode and the (A-2) metal electrode are preferably made of the same metal, but may be made of different metals. As the (A) metal electrode, metals such as copper, gold, silver, aluminum, platinum, titanium, chromium, molybdenum, zinc, nickel, and magnesium can be used. An alloy or a laminate of these metals may also be used. In addition, an electrically conductive metal oxide such as ITO or ZnO may be used. Among them, a copper electrode and a copper electrode including a barrier metal are preferable from the viewpoint of electrical conductivity and economic efficiency (cost). Examples of the barrier metal include nickel, chromium, and molybdenum. In the case where the (A) metal electrode is a copper electrode, when the thickness of an oxide film at the bonding interface of the electrode is 0 nm or more and 200 nm or less, the resistance of the electrode decreases, which is preferable.

The laminate to be produced in the method for producing a laminate of the present invention uses a substrate having a (B-1) resin layer and a (B-2) resin layer (these two layers may hereinafter be collectively referred to as "(B) resin layer"). Alternatively, the laminate of the present invention has a (B-1) resin layer and a (C) inorganic insulating layer. The laminate of the present invention preferably has a (B-1) resin layer and a (B-2) resin layer. That is, the second substrate includes an exposed (A-2) metal electrode and an exposed (B-2) resin layer, or an exposed (A-2) metal electrode and an exposed (C) inorganic insulating layer, and it is preferable that the second substrate includes the exposed (A-2) metal electrode and the exposed (B-2) resin layer provided on the same face of the substrate body. The (B-1) resin layer and the (B-2) resin layer are preferably made of the same resin, but may be made of different resins. At least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1) or the formula (2). This facilitates bonding at a low temperature, and improves the adhesive force and insulation reliability of the resulting laminate.

That is, when the second substrate includes the exposed (A-2) metal electrode and the exposed (B-2) resin layer, the laminate includes the (B-1) resin layer and the (B-2) resin layer. In this case, at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1) or the formula (2). When the second substrate includes the exposed (A-2) metal electrode and the exposed (C) inorganic insulating layer, the laminate does not include a (B-2) resin layer. In this case, the (B-1) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1) or the formula (2).

The expression "at least one of the (B-1) resin layer and the (B-2) resin layer" described above shall represent at least one of the (B-1) resin layer and the (B-2) resin layer when both the (B-1) resin layer and the (B-2) resin layer are included in the laminate, and represent the (B-1) resin layer when the laminate does not contain the (B-2) resin layer.

While at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1) or the formula (2), and above all, it is preferable that at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1) from the viewpoint of adhesive force.

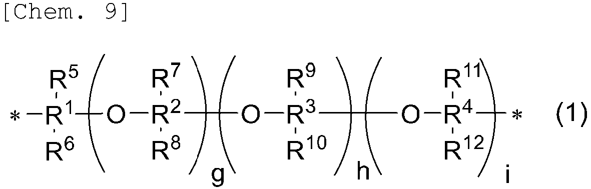

In the formula (1), R¹ to R⁴ each independently represent an alkylene group having 1 to 6 carbon atoms. R⁵ to R¹² each independently represent a hydrogen atom, a fluorine atom, or an alkyl group having 1 to 6 carbon atoms; parenthesized structures are different from each other; g, h, and i each independently represent an integer of 0 to 35, and g + h + i > 0. sign * represents a bonding site. Preferred examples of R¹ to R⁴ include a pethylene group, a propylene group, and a butylene group, and preferred examples of R⁵ to R¹² include a hydrogen atom, a methyl group, and an ethyl group.

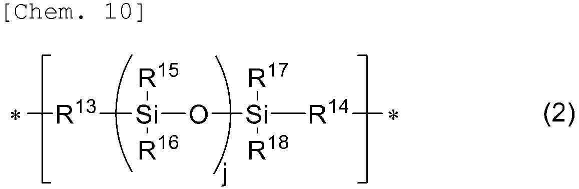

In the formula (2), j is a natural number of 1 to 50. R¹³ and R¹⁴ each independently represent an alkylene group having 1 to 30 carbon atoms, an alkenylene group having 2 to 10 carbon atoms, an alkynylene group having 2 to 10 carbon atoms, or a phenylene group having 6 to 20 carbon atoms. R¹⁵ to R¹⁸ each independently represent an alkyl group having 1 to 30 carbon atoms, a phenyl group, or a phenoxy group; sign * represents a bonding site. Preferred examples of R¹³ and R¹⁴ include a propylene group, a butylene group, a vinylene group, and a phenylene group, and preferred examples of R¹⁵ to R¹⁸ include a methyl group and a phenyl group.

Examples of the polyimide precursors include those obtained by reacting a tetracarboxylic acid and a derivative thereof with a diamine and a derivative thereof. As the polyimide precursors, for example, polyamic acid, polyamide acid esters, polyamic acid amides, or polyisoimides can be considered. Examples of the derivatives of the tetracarboxylic acids include tetracarboxylic dianhydrides, tetracarboxylic dichlorides, or tetracarboxylic acid active diesters (these may hereinafter be collectively referred to as "(tetracarboxylic acid analogue"). Examples of the diamine derivative include compounds in which an amino moiety is isocyanated or trimethylsilylated. (These may hereinafter be collectively referred to as "diamine analogue".) By using a compound containing the structure of the formula (1) or the formula (2) for at least one of the tetracarboxylic acid analogue and the diamine analogue, a polyimide precursors containing these structures are obtained.

Examples of the anhydride (dianhydride) of a tetracarboxylic acid having the siloxane structure represented by the formula (2) include X-22-168AS, X-22-168 A, X-22-168B, and X-22-168-P5-B.

Examples of commercially available products of the diamine analogue having an alkylene oxide structure represented by the formula (1) include ED-600, ED-900, ED-2003, EDR-148, EDR-176, D-200, D-400, D-2000, THF-100, THF-140, THF-170, RE-600, RE-900, RE-2000, RP-405, RP-409, RP-2005, RP-2009, RT-1000, HE-1000, HT-1100, and HT-1700 (trade names, manufactured by HUNTSMAN Corporation). Examples of the diamine analogue having a siloxane structure represented by the formula (2) include bis(3-aminopropyl)tetramethyldisiloxane, bis(p-aminophenyl)octamethylpentasiloxane, PAM-E, KF-8010, X-22-161A, X-22-161B, KF-8012, KF-8008, X-22-1660B-3, and X-22-9409 (trade names, manufactured by Shin-Etsu Chemical Co., Ltd.).

The polyimide precursor may have residues of other tetracarboxylic acid analogues. By containing residues of other tetracarboxylic acid analogues, various functions such as elastic modulus and adhesion can be imparted. Examples of other tetracarboxylic acid analogues include residues of 1,2,4,5-benzenetetracarboxylic acid (pyromellitic acid),3,3',4,4'-biphenyltetracarboxylic acid,2,3,3',4'-biphenyltetracarboxylic acid,2,2',3,3'-biphenyltetracarboxylic acid,1,2,5,6-naphthalenetetracarboxylic acid,1,4,5,8-naphthalenetetracarboxylic acid,2,3,6,7-naphthalenetetracarboxylic acid,3,3', 4,4'-benzophenonetetracarboxylic acid,2,2', 3,3'-benzophenonetetracarboxylic acid,bis(3,4-dicarboxyphenyl)methane,bis(2,3-dicarboxyphenyl)methane,1,1-bis(3,4-dicarboxyphenyl)ethane,1,1-bis(2,3-dicarboxyphenyl)ethane,2,2-bis(3,4-dicarboxyphenyl)propane,2,2-bis(2,3-dicarboxyphenyl)propane,2,2'-bis[4-(3,4-dicarboxyphenoxy)phenyl]propane,2,2-bis(3,4-dicarboxyphenyl)hexafluoropropane,2,2-bis(2,3-dicarboxyphenyl)hexafluoropropane,bis(3,4-dicarboxyphenyl) sulfone,bis(3,4-dicarboxyphenyl) ether,2,3,5,6-pyridinetetracarboxylic acid or 3,4,9,10-perylenetetracarboxylic acid,N,N'-bis[5,5'-hexafluoropropane-2,2-diyl-bis(2-hydroxyphenyl)]bis(3,4-dicarboxybenzoic acid amide),bicyclo[2.2.2]oct-7-ene-2,3,5,6-tetracarboxylic acid,1,2,4,5-cyclohexanetetracarboxylic acid,1,2,3,4-cyclopentanetetracarboxylic acid,1,2,3,4-cyclobutanetetracarboxylic acid or 2 ,3,4,5-tetrahydrofurantetracarboxylic acid,butane-1,2,3,4-tetracarboxylic acid, or their tetracarboxylic dianhydrides, tetracarboxylic acid dichlorides or tetracarboxylic acid active diesters, their tetracarboxylic dianhydrides,tetracarboxylic acid dichlorides ortetracarboxylic acid active diesters. The polyimide precursor may have either these residues singly or two or more of these residues in combination.

The polyimide precursor may have residues of other diamine analogues. By containing residues of other diamine analogues, various functions such as elastic modulus and adhesion can be imparted. Examples of other diamine analogues include residues of m-phenylenediamine, p-phenylenediamine, 3,5-diaminobenzoic acid, 4,4'-diaminobiphenyl, bis(4-aminophenoxy)biphenyl, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, 2,2'-bis(trifluoromethyl)-4,4'-diaminobiphenyl, dimercaptophenylenediamine, 1,5-naphthalenediamine, 2,6-naphthalenediamine, 9,10-anthracenediamine, 4,4'-diaminobenzanilide, 3,4'-diaminodiphenyl ether, 4,4'-diamino diphenyl ether, 3-carboxy-4,4'-diaminodiphenyl ether, 3-sulfonic acid-4,4'-diaminodiphenyl ether, bis[4-(4-aminophenoxy)phenyl] ether, 1,4-bis(4-aminophenoxy)benzene, 1,3-bis(3-aminophenoxy)benzene, 1,3-bis(4-aminophenoxy)benzene, 3,4'-diaminodiphenylmethane, 4,4'-diaminodiphenylmethane, 2,2-bis(4-aminophenyl)hexafluoropropane, 3,3'-diaminodiphenyl sulfone, 3,4'-diaminodiphenyl sulfone, 4,4'-diaminodiphenyl sulfone, bis(4-aminophenoxyphenyl) sulfone, bis(3-aminophenoxyphenyl) sulfone, 2,7-diaminofluorene, 9,9-bis(4-aminophenyl)fluorene, 2-(4-aminophenyl)-5-aminobenzoxazole, 2-(3-aminophenyl)-5-aminobenzoxazole, 2-(4-aminophenyl)-6-aminobenzoxazole, 2-(3-aminophenyl)-6-aminobenzoxazole, 1,4-bis(5-amino-2-benzoxazolyl)benzene, 1,4-bis(6-amino-2-benzoxazolyl)benzene, 1,3-bis(5-amino-2-benzoxazolyl)benzene, 1,3-bis(6-amino-2-benzoxazolyl)benzene, 2,6-bis(4-aminophenyl)benzobisoxazole, 2,6-bis(3-aminophenyl)benzobisoxazole, bis[(3-aminophenyl)-5-benzoxazolyl], bis[(4-aminophenyl)-5-benzoxazolyl], bis[(3-aminophenyl)-6-benzoxazolyl], bis[(4-aminophenyl)-6-benzoxazolyl], 3,4'-diaminodiphenyl sulfide, 4,4'-diaminodiphenyl sulfide, 4-aminophenyl 4-aminobenzoate, 1,3-bis(4-anilino)tetramethyldisiloxane, ethylenediamine, 1,3-diaminopropane, 2-methyl-1,3-propanediamine, 1,4-diaminobutane, 1,5-diaminopentane, 2-methyl-1,5-diaminopentane, 1,6-diaminohexane, 1,2-cyclohexanediamine, 1,4-cyclohexanediamine, bis(4-aminocyclohexyl)methane, 1,7-diaminoheptane, 1,8-diaminooctane, 1,9-diaminononane, 1,10-diaminodecane, 1,11-diaminoundecane, 1,12-diaminododecane, and dimer diamine.

In addition, owing to having a phenolic hydroxy group, the adhesive force at the time of direct bonding can be improved, and when the metal electrode is copper or silver, corrosion can be reduced. Therefore, the polyimide precursor preferably has a residue of a bisaminophenol compound. Examples of the residue of the bisaminophenol compound include residues of bis(3-amino-4-hydroxyphenyl) methylene, bis[N-(3-aminobenzoyl)-3-amino-4-hydroxyphenyl] sulfone, bis[N-(4-aminobenzoyl)-3 amino-4-hydroxyphenyl] sulfone, bis(3-amino-4-hydroxyphenyl) sulfone, bis(3-amino-4-hydroxyphenyl)propane, 2,2'-bis[N-(3-aminobenzoyl)-3-amino-4-hydroxyphenyl]propane, 2,2'-bis[N-(4-aminobenzoyl)-3-amino-4-hydroxyphenyl]propane, 9,9-bis(3-amino-4-hydroxyphenyl)fluorene, 9,9-bis[N-(3-aminobenzoyl)-3-amino-4-hydroxyphenyl]fluorene, 9,9-bis[N-(4-aminobenzoyl)-3-amino-4-hydroxyphenyl]fluorene, N,N'-bis(3-aminobenzoyl)-2,5-diamino-1,4-dihydroxybenzene, N,N'-bis(4-aminobenzoyl)-2,5-diamino-1,4-dihydroxybenzene, N,N'-bis(4-aminobenzoyl)-4,4'-diamino-3,3-dihydroxybiphenyl, N,N'-bis(3-aminobenzoyl)-3,3'-diamino-4,4-dihydroxybiphenyl, N,N'-bis(4-aminobenzoyl)-3,3'-diamino-4,4-dihydroxybiphenyl, 3,3'-diamino-4,4'-biphenol, bis(3-amino-4-hydroxyphenyl) methane, 1,1-bis(3-amino-4-hydroxyphenyl) ethane, 2,2-bis(3-amino-4-hydroxyphenyl)propane, 2,2-bis(3-amino-4-hydroxyphenyl) hexafluoropropane, and 2,2-bis[3-(3-aminobenzamido)-4-hydroxyphenyl]hexafluoropropane.

Further, the weight-average molecular weight of resin can be adjusted or a functional group different from those in a molecule can be introduced by capping a resin terminal with a monoamine, an acid anhydride, an acid chloride, or a monocarboxylic acid.

Preferable examples of the monoamine include 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used.

Preferable examples of the acid anhydride, the acid chloride, and the monocarboxylic acid include acid anhydrides such as phthalic anhydride, maleic anhydride, nadic acid anhydride, cyclohexanedicarboxylic acid anhydride, and 3-hydroxyphthalic acid anhydride, monocarboxylic acids such as 3-carboxyphenol, 4-carboxyphenol, 3-carboxythiophenol, 4-carboxythiophenol, 1-hydroxy-7-carboxynaphthalene, 1-hydroxy-6-carboxynaphthalene, 1-hydroxy-5-carboxynaphthalene, 1-mercapto-7-carboxynaphthalene, 1-mercapto-6-carboxynaphthalene, and 1-mercapto-5-carboxynaphthalene, monoacid chloride compounds in which carboxyl groups thereof are converted into an acid chloride, monoacid chloride compounds in which only one carboxyl group of dicarboxylic acids, such as terephthalic acid, phthalic acid, maleic acid, cyclohexanedicarboxylic acid, 1,5-dicarboxynaphthalene, 1,6-dicarboxynaphthalene, 1,7-dicarboxynaphthalene, and 2,6-dicarboxynaphthalene, is converted into an acid chloride, and active ester compounds produced by reacting a monoacid chloride compound with N-hydroxybenzotriazole or N-hydroxy-5-norbornene-2,3-dicarboximide. Two or more of these may be used.

As the polyimide precursors, polyamic acid or polyamide acid esters are preferable, and examples thereof include polyimide precursors containing a structural unit represented by formula (3).

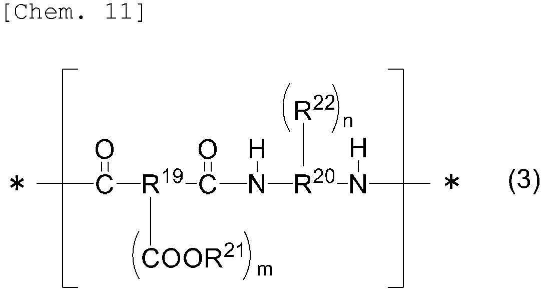

In the formula (3), R¹⁹ represents an organic group having a valence of 4 to 6, and R²⁰ represents an organic group having a valence of 2 to 10. A plurality of R²²s each independently represent an organic group having 1 to 10 carbon atoms or a hydroxy group, and n represents an integer of 0 to 8. A plurality of R²¹_{S} may be the same or different and represent a hydrogen atom or a monovalent organic group having 1 to 30 carbon atoms. m represents an integer 2 to 4. R¹⁹-(COOR²¹)ₘ represents the aforementioned tetracarboxylic acid and/or a derivative residue thereof. R²⁰-(R²²)ₙ represents the aforementioned diamine and/or a derivative residue thereof. Sign * represents a point of bonding. Examples of the organic group having 1 to 30 carbon atoms of R²¹ include hydrocarbon groups such as a methyl group, an ethyl group, a n-propyl group, an i-propyl group, a n-butyl group, a t-butyl group, a n-pentyl group, a neopentyl group, a n-hexyl group, a s-hexyl group, a n-heptyl group, a n-octyl group, and a s-octyl group; alkylene oxide groups such as a 2-methoxyethyl group, a 2-methoxypropyl group, a diethylene glycol methyl group, and a dipropylene glycol methyl group; and unsaturated bond-containing organic groups such as an ethyl 2-(meth)acrylate group, a propyl 2-(meth)acrylate group, a butyl 2-(meth)acrylate group, an allyl group, and a butenyl group.

Examples of the polyimide include products obtained by cyclodehydrating a polyamic acid, a polyamide acid ester, a polyamic acid amide, or a polyisoimide described above by a reaction with heat, an acid, a base, or the like. The polyimide has a tetracarboxylic acid and/or its derivative residue and a diamine and/or its derivative residue. To form a polyimide as the (B) resin layer on the first substrate or the second substrate, a method of applying a polyimide precursor solution onto a substrate, drying the polyimide precursor solution, and heating the residue to a temperature equal to or more than imidization is the most simple and preferable.

Examples of the polyimide include a polyimide containing a structural unit represented by the following formula (4).

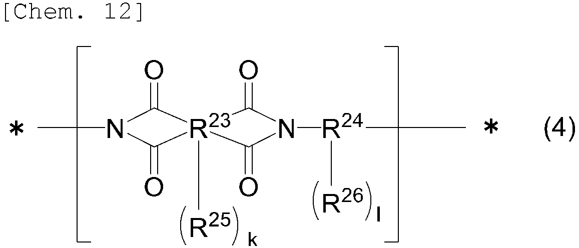

In the formula (4), R²³ represents an organic group having a valence of 4 to 10, and R²⁴ represents an organic group having a valence of 2 to 8. R²⁵ and R²⁶ each represent a hydroxy group or an organic group having 1 to 20 carbon atoms, and each may be the same type of group at every occurrence or may include different groups. k and l each represent an integer of 0 to 6. R²³-(R²⁵)ₖ represents the aforementioned tetracarboxylic acid and/or a derivative residue thereof. R²⁴-(R²⁶)ₗ represents the aforementioned diamine and/or a derivative residue thereof. Sign * represents a point of bonding.

Examples of the polybenzoxazole precursor include polyhydroxyamides obtained by reacting a dicarboxylic acid and a derivative thereof with a bisaminophenol compound or the like as a diamine.

Examples of the dicarboxylic acid include terephthalic acid, isophthalic acid, dimer acid, diphenyl ether dicarboxylic acid, bis(carboxyphenyl)hexafluoropropane, biphenyl dicarboxylic acid, benzophenone dicarboxylic acid, and triphenyl dicarboxylic acid, and examples of tricarboxylic acid include trimellitic acid, trimesic acid, diphenyl ether tricarboxylic acid, and biphenyl tricarboxylic acid. These compounds may be used singly or two or more of them may be used in combination.

Examples of the bisaminophenol include the bisaminophenol compounds enumerated as examples for the polyimide precursor.

Examples of the polybenzoxazole precursor to be used in the present invention include those containing a structural unit represented by the following formula (5).

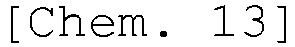

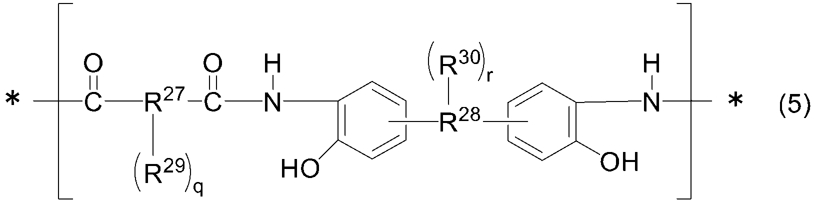

In the formula (5), R²⁷ represents an organic group having a valence of 2 to 6, and R²⁸ represents a single bond or an organic group having a valence of 2 to 6. R²⁹ and R³⁰ each represent an organic group having 1 to 10 carbon atoms or a hydroxy group. q and r each represent an integer of 0 to 4. R²⁷-(R²⁹)_{q} represents the aforementioned dicarboxylic acid and/or a derivative residue thereof. R²⁸-(R³⁰)ᵣ represents the aforementioned bisaminophenol compound and/or a derivative residue thereof. Sign * represents a point of bonding.

Examples of the polybenzoxazole include a polybenzoxazole obtained by cyclodehydrating a dicarboxylic acid and a bisaminophenol compound as a diamine based on a reaction using a polyphosphoric acid, and a polybenzoxazole precursor obtained by cyclodehydrating the polyhydroxyamide by heating or a reaction using a phosphoric anhydride, a base, a carbodiimide compound, or the like.

Examples of the polybenzoxazole include those containing a structural unit represented by formula (6).

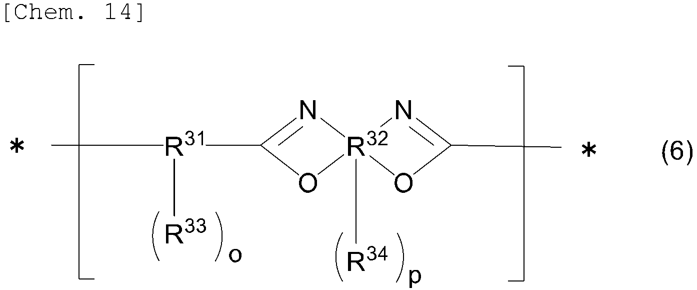

In the formula (6), R³¹ represents an organic group having a valence of 2 to 6, and R³² represents an organic group having a valence of 4 to 6. R³³ and R³⁴ each independently represent an organic group having 1 to 10 carbon atoms or a hydroxy group. o represents an integer of 0 to 4, and p represents an integer of 0 to 2. R³¹-(R³³)ₒ represents the aforementioned dicarboxylic acid and/or a derivative residue thereof. In particular, a dimer acid residue is preferable from the viewpoint of low dielectric dissipation factor. R³²-(R³⁴)ₚ represents the aforementioned bisaminophenol compound and/or a derivative residue thereof. Sign * represents a point of bonding.

Examples of the polyamide include those obtained by dehydration condensation of a dicarboxylic acid and a diamine compound based on a reaction using polyphosphoric acid.

Examples of the polyamide include a polyamide containing a structural unit represented by the following formula (7).

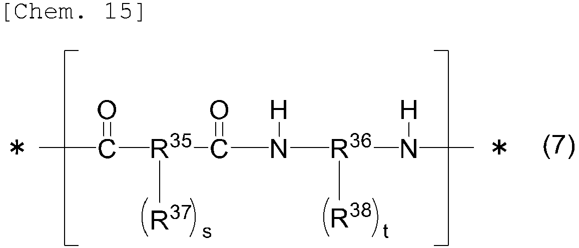

In the formula (7), R³⁵ and R³⁶ each represent an organic group having a valence of 2 to 6. R³⁷ and R³⁸ each independently represent an organic group having 1 to 10 carbon atoms or a hydroxy group. s represents an integer of 0 to 4, and t represents an integer of 0 to 4. R³⁵-(R³⁷)ₛ represents the aforementioned dicarboxylic acid and/or a derivative residue thereof, and R³⁶-(R³⁸)ₜ represents a diamine compound excluding the aforementioned bisaminophenol compound and/or a derivative residue thereof. Sign * represents a point of bonding.

Further, the (B) resin layer may contain a copolymer composed of two or more substances selected from the group consisting of polyimides, polyimide precursors, polybenzoxazoles, polybenzoxazole precursors, and polyamides.

It is preferable that the resin contained in at least one of the (B-1) resin layer and the (B-2) resin layer contains two or more structures represented by the formula (9) because the coefficient of thermal expansion can be kept low. 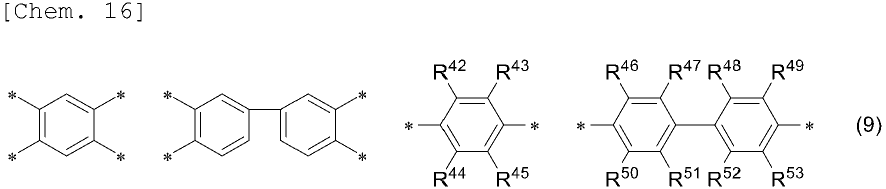 wherein sign * represents a bonding site; R¹² to R⁵³ each independently represent a hydrogen atom, a fluorine atom, a hydroxy group, or a hydrocarbon group having 1 to 6 carbon atoms, which may be partially or fully substituted with one or more among a fluorine atom, a hydroxy group, and a carboxyl group.

Examples of the acid dianhydride to afford the acid dianhydride residue represented by the formula (9) include pyromellitic dianhydride and 3,3',4,4'-biphenyltetracarboxylic dianhydride.

Examples of the diamine to afford the diamine residue represented by the formula (9) include p-phenylenediamine, benzidine, 4,4'-bis(4-aminophenoxy)biphenyl, 4,4'-[[1,1'-biphenyl]-4,4'-diylbis(oxy)]bis(3-methylaniline), and 4,4'-[[1,1'-biphenyl]-4,4'-diylbis(oxy)]bis[3-(trifluoromethyl)aniline].

Acid dianhydrides to afford the acid dianhydride residues represented by the formula (9) or diamines to afford the diamine residues represented by the formula (9) may have a substituent. Examples of the acid dianhydrides to afford the acid dianhydride residues represented by the formula (9) or the diamines to afford the diamine residues represented by the formula (9) include 2,5-diaminotoluene, 2,5-dimethyl-1,4-phenylenediamine, 2-(trifluoromethyl)-1,4-phenylenediamine, 2,3,5,6-tetrafluoro-1,4-phenylenediamine, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 2,2',5,5'-tetramethyl-4,4'-diaminobiphenyl, 3,3',5,5'-tetramethyl-4,4'-diaminobiphenyl, and 4,4'-diaminooctafluorobiphenyl.

In the production method of the present invention, the second substrate may have a (C) inorganic insulating layer. That is, the second substrate may include an exposed (A-2) metal electrode and an exposed (C) inorganic insulating layer. Owing to having the (C) inorganic insulating layer, it is possible to ensure a high bonding yield in bonding at a high temperature and high insulation reliability of a resulting laminate. As the (C) inorganic insulating layer, an inorganic insulating layer of silicon oxide (SiO₂), silicon nitride (SiN), silicon nitride carbide (SiCN), silicon nitride oxide (SiON), titanium oxide (TiO₂), zirconium oxide (ZrO₂), aluminum oxide (Al₂O₃), or the like can be used. In addition, a laminate of these inorganic insulating layers may also be used. Among them, an inorganic insulating layer including SiO₂, SiN, or SiCN is preferable from the viewpoint of insulating properties and economic efficiency (cost).

Preferably, at least one of the (B-1) resin layer and the (B-2) resin layer further contains an antioxidant. By containing the antioxidant, oxidative degradation of the resin to be mixed is suppressed. In addition, due to the rust prevention action on a metal material, metal oxidation by moisture or the like from the outside, and accompanying reduction in adhesion and peeling can be suppressed. These actions improve the long-term reliability of the laminate.

As the antioxidant, a hindered phenol antioxidant-based or a hindered amine-based antioxidant is preferred. In addition, the number of phenol groups or amino groups in one molecule is preferably 2 or more, and more preferably 4 or more because they easily achieve an antioxidant effect, and among them, a compound represented by the following formula (8) is preferable. Containing the compound represented by the formula (8) makes it possible to suppress mechanical properties and peeling from a metal material in a cured film after a reliability test such as a high temperature preservability test.

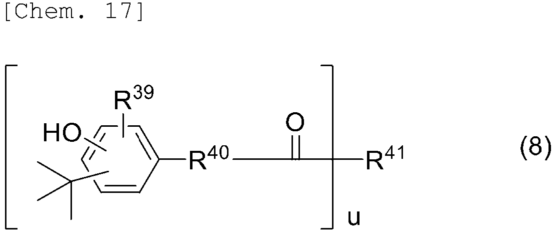

In the formula (8), R³⁹ represents a hydrogen atom or an alkyl group having 2 or more carbon atoms, and R⁴⁰ represents an alkylene group having 2 or more carbon atoms. R⁴¹ represents an organic group having a valence of 1 to 4 and containing at least one among an alkylene group having 2 or more carbon atoms, an 0 atom, and an N atom. u represents an integer 1 to 4.

Examples of the monovalent organic group suitable as R⁴¹ include alkyl groups, cycloalkyl groups, alkoxy groups, alkyl ether groups, alkylsilyl groups, alkoxysilyl groups, aryl groups, aryl ether groups, a carboxyl group, an allyl group, a vinyl group, and heterocyclic groups, and examples of the divalent organic group include a carbonyl group, - O-, -NH-, -NHNH-, -NHCO-, and -COO-. Examples of the trivalent or tetravalent organic group suitable as R⁴¹ include groups each resulting from replacement of a hydrogen atom of the monovalent or divalent organic group described above with a bonding point. Additional examples include a combination of those groups, which may further have a substituent. Examples of the compound represented by the formula (8) include, but are not limited to, the following compounds.

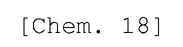

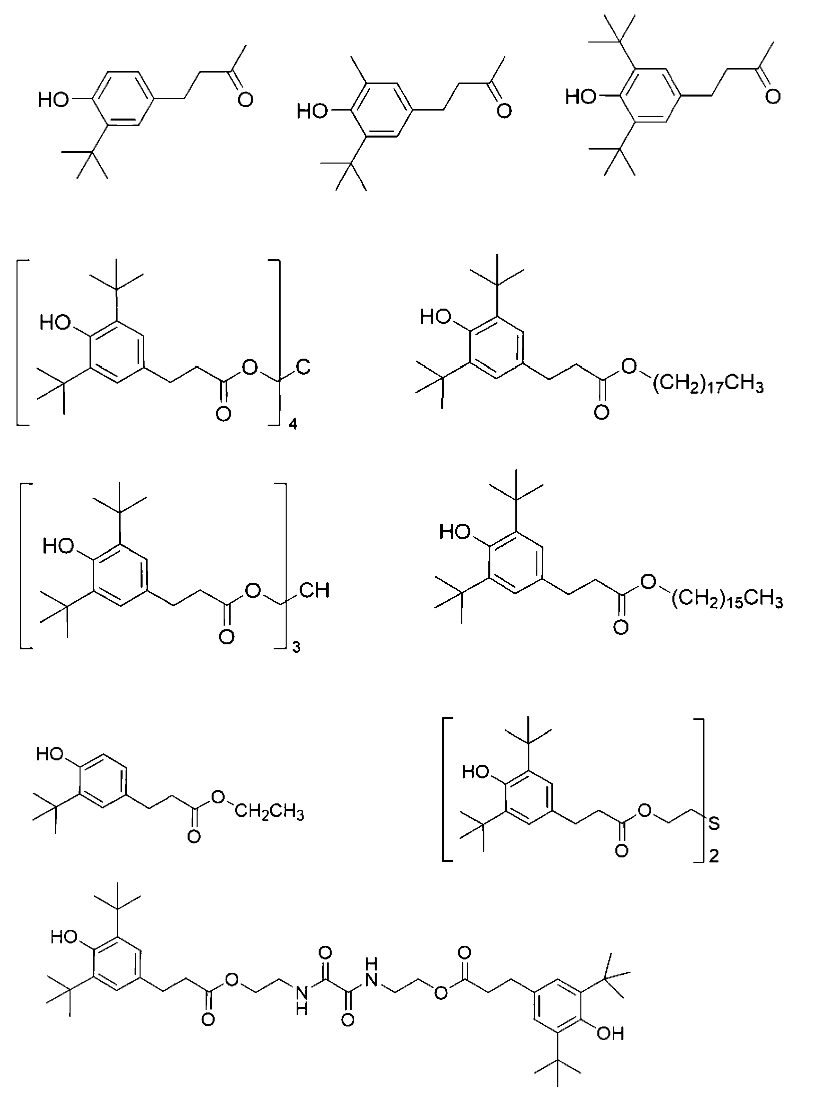

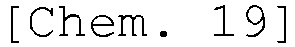

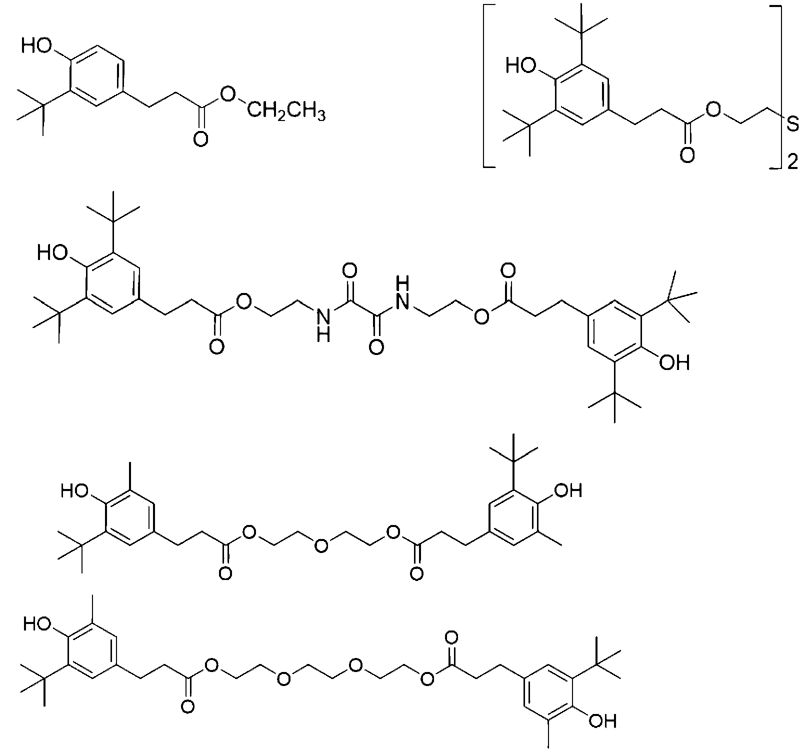

The method for forming the (B) resin layer is not particularly limited, but for example, the (B) resin layer can be formed from a resin composition including one or more resins which are selected from the group consisting of polyimide, polyimide precursors, polybenzoxazole, polybenzoxazole precursors, polyamide excluding the polyimide precursors and the polybenzoxazole precursors, and copolymers thereof and which have a group represented by formula (1) or formula (2) and a solvent, namely, a resin composition having the same composition as that of the resin composition of the present invention. The resin composition is preferably in a liquid form or a sheet form. In the case of a liquid form, the (B) resin layer can be obtained through a drying step in which the resin composition is applied onto a substrate body by a known method such as spin coating, slit die coating, spray coating, or inkjet coating, and then the coating film is dried by heating with a hot plate, an oven, infrared rays, or the like. In the case of a sheet form, the (B) resin layer can be formed by lamination. After the lamination, a drying step may be similarly performed. In addition, the (B) resin layer may be cured by at least one treatment of light and heat, as necessary, as long as the characteristics as the (B) resin layer are not impaired. In the case of curing by heat, the curing temperature may be appropriately selected in the range of 100°C or more and 400°C or less, and the curing time may be selected from 3 minutes to 3 hours according to the purpose. In particular, heat curing in the range of 170°C or more and 250°C or less is preferable because the load on the substrate body is small. When the resin composition has photosensitivity, a pattern such as a via hole may be formed in the (B) resin layer through exposure to light and development steps, as necessary. That is, it is preferable that at least one of the (B-1) resin layer and the (B-2) resin layer is formed by curing, at 170°C or more and 250°C or less, a resin composition including one or more resins which are selected from the group consisting of polyimide, polyimide precursors, polybenzoxazole, polybenzoxazole precursors, polyamide excluding the polyimide precursors and the polybenzoxazole precursors, and copolymers thereof and which have a group represented by formula (1) or formula (2), and a solvent.

The elastic modulus of at least one of the (B-1) resin layer and the (B-2) resin layer is preferably 1.5 GPa or more and 7.0 GPa or less, and more preferably 2.5 GPa or more and 5 GPa or less. Within such a range, it is easy to obtain high adhesive strength while suppressing generation of voids due to minute foreign matters of dicing.

The coefficient of thermal expansion of at least one of the (B-1) resin layer and the (B-2) resin layer in a temperature range of 50°C to 150°C is preferably 10 ppm/K or more and 40 ppm/K or less, more preferably 15 pm/K or more and 30 ppm/K or less, and still more preferably 20 ppm/K or more and 25 ppm/K or less. By controlling the coefficient of thermal expansion to such a range, the expansion difference between the (A) metal electrode and the (B) resin layer at the time of bonding is reduced, so that the yield of the bonding process can be increased.

At least one of the (B-1) resin layer and the (B-2) resin layer may form a crosslinked structure. The elastic modulus can be increased by forming the crosslinked structure. The crosslinked structure can be formed by making the resin composition contain a crosslinking agent and subjecting the resulting resin composition to curing treatment. Examples of the crosslinking agent include, but are not limited to, a methylol compound, an epoxy compound, and an oxetane compound. At the time of step (I) in which the (B-1) resin layer is included in the first substrate or step (II) in which the (B-2) resin layer is included in the second substrate, the presence or absence of a crosslinked structure is determined.

Examples of the epoxy compound include bisphenol A diglycidyl ether, cresol novolak resin type polyfunctional glycidyl ether, ethylene glycol diglycidyl ether, and hydrogenated bisphenol A diglycidyl ether. Examples thereof specifically include EPOLIGHT (registered trademark) 40E, EPOLIGHT 100E, EPOLIGHT 200E, EPOLIGHT 400E, EPOLIGHT 70P, EPOLIGHT 200P, EPOLIGHT 400P, EPOLIGHT 1500NP, EPOLIGHT 80MF, EPOLIGHT 4000, EPOLIGHT 3002 (trade names, manufactured by Kyoeisha Chemical Co., Ltd.), DENACOL EX-212L, DENACOL EX-214L, DENACOL EX-216L, DENACOL EX-321L, DENACOL EX-850L (trade names, manufactured by Nagase ChemteX Corporation), EPIKOTE 828, EPIKOTE 1002, EPIKOTE 1750, EPIKOTE 1007, YX8100-BH30, E1256, E4250, E4275 (trade names, manufactured by Japan Epoxy Resins Co., Ltd.), EPICLON EXA-9583, EPICLON N666, EPICLON N695, HP4032, HP7200 (trade names, manufactured by DIC Corporation), TECHMORE VG3101L (trade name, manufactured by Printec Corporation), TEPIC S, TEPIC G, TEPIC P (trade names, manufactured by Nissan Chemical Corporation), Epotohto YH-434L (trade name, manufactured by Tohto Kasei Co., Ltd.), GAN, GOT, EPPN502H, NC3000, or NC6000 (trade names, manufactured by Nippon Kayaku Co., Ltd.), YDPN-638, YDCN-700-7, YDCN-700-10, YDCN-704, and YDCN-704A (trade names, manufactured by NIPPON STEEL Chemical & Material Co., Ltd.).

As the oxetane compound, a known oxetane compound may be contained. Examples thereof include OXT-101, OXT-121, OXT-212, and OXT-221 (trade names, manufactured by TOAGOSEI CO., LTD.), ETERNACOLL EHO, ETERNACOLL OXBP, ETERNACOLL OXTP, ETERNACOLL OXMA, ETERNACOLL OXIPA (trade names, manufactured by UBE Corporation), and oxetanized phenol novolac.

As the methylol compound, a known methylol compound may be contained. Preferable examples of the compound include DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (trade names, manufactured by Honshu Chemical Industry Co., Ltd.), NIKALAC (registered trademark) MX-290, NIKALAC MX-280, NIKALAC MX-270, NIKALAC MX-279, NIKALAC MW-100LM, and NIKALAC MX-750LM (trade names, manufactured by Sanwa Chemical Co., Ltd.).

At least one of the (B-1) resin layer and the (B-2) resin layer also may be formed from a resin composition containing a photosensitive agent. Forming from a photosensitive material can simplify a method for producing the first substrate and the second substrate, and makes it possible to control the elastic modulus through promotion of the reaction of the crosslinking agent. As the photosensitive agent, a photopolymerization initiator or a photoacid generator is preferable. In particular, a material containing a photoacid generator is preferable from the viewpoint of resolution. Specific examples of the photopolymerization initiator and the photoacid generator include the same ones as those described in a patent document JP 2018-165819 A. Preferable examples are also the same as those described therein.

The first substrate and the second substrate to be used for the method for producing a laminate of the present invention each have a substrate body. The substrate body refers to, for example in the first substrate, a plate-like article other than the (A-1) metal electrode and the (B-1) resin layer. At least one of the substrate body of the first substrate and the substrate body of the second substrate preferably contains one or more selected from the group consisting of silicon, niobium lithate, tantalum lithate, gallium nitride, silicon carbide, gallium arsenide, and indium phosphide. Silicon is suitably used for the production of laminates having such functions as arithmetic processing and information storage. Niobium lithate and tantalum lithate are suitably used for the production of laminates having a function of filtering an electric signal. Gallium nitride and silicon carbide are suitably used for the production of laminates having a power control function. Gallium arsenide and indium phosphide are suitably used for the production of laminates having a light receiving and emitting function.

The bonding strength in a die shear test between the first substrate and the second substrate of the laminate to be obtained by the method for producing a laminate of the present invention can be used when the bonding strength is 5 MPa or more, and from the viewpoint of reliability, the bonding strength is preferably 10 MPa or more, and more preferably 20 MPa or more.

Next, a method for producing the laminate of the present invention will be described. First, step I and step II of preparing the first substrate and the second substrate will be described.

Step (I) is a step of preparing a first substrate including an exposed (A-1) metal electrode and an exposed (B-1) resin layer provided on the same face of a substrate body.

Step (II) is a step of preparing a second substrate including an exposed (A-2) metal electrode and an exposed (B-2) resin layer provided on the same face of a substrate body.

In the first substrate and the second substrate, a substrate on which a circuit of a passive component and/or an active component is formed can be used as a substrate body. By using such a substrate body, the resulting laminate has a function as a semiconductor or MEMS. The first substrate and the second substrate are obtained by forming an (A) metal electrode and a (B) resin layer on each of the substrate bodies, followed by smoothing. The metal electrode (A) can be formed by a known method, and examples of the method include a subtract process and a semi-additive process. Formation of a copper electrode by the semi-additive process will be described as a specific example. A seed layer of Ti, Ni, or the like is formed on a substrate body by sputtering, a dry film resist is patterned, a copper electrode pattern is formed by electrolytic plating, and then the resist is removed. Then, through a subsequent step of seed layer removal, a copper electrode pattern can be formed. Thereafter, a resin layer is formed by the method for forming (B) resin layer described above. As a result, a substrate including the (A) metal electrode and the (B) resin layer provided on the same face is obtained.

Each of the (A) metal electrode and the (B) resin layer can be exposed by smoothing the substrate including the (A) metal electrode and the (B) resin layer. Thus, the first substrate and the second substrate are obtained. In the smoothing step, it is preferable to use a surface planer using chemical mechanical polishing (CMP) or a diamond bite. CMP is preferable because it can reduce the surface roughness and increase the bonding strength. That is, at least one of the step (I) and the step (II) preferably includes a smoothing step by at least one of chemical mechanical polishing and a surface planer. In addition, a step of performing CMP after performing the surface planer is preferable from the viewpoint of shortening the process time.

In the smoothed first substrate and second substrate, a face on which the (A) metal electrode and the (B) resin layer are provided, namely, a face on a side on which the first substrate and the second substrate are laminated together is preferably subjected to plasma treatment. By the activation by plasma treatment, the bonding strength can be increased. The plasma treatment is preferably performed in an inert gas atmosphere, and the oxygen volume concentration is more preferably 1 vol% or less in an inert gas atmosphere, still more preferably 0.1 vol% or less, and particularly preferably 0.01 vol% or less. By adjusting the oxygen volume concentration to less than 1 vol%, it is possible to suppress the oxidation of the metal electrode as the outermost layer to maintain conductivity, and also possible to suppress the oxidation of the resin layer to suppress a decrease in bonding force. Examples of the inert gas to be used for the plasma treatment include argon and helium, and to maintain the activated state for a long time after the treatment, helium is preferably contained as the inert gas to be turned into plasma. Since the activation energy of helium is low, the activation energy state of the resin layer activated by helium plasma is low and becomes a relatively stable state. Therefore, the activation state is elongated, a time delay from the plasma treatment to direct bonding is secured, and the process margin is improved. Examples of plasma processing for direct bonding containing helium are shown in Wafer Level Package Symposium 2022 "Atmospheric Plasma System for In-Line Surface Activation of Die-to-Wafer Direct and Hybrid Bonding" presentation and the like, and this technique can also be used in the present invention.

Next, a description will be made to the step (III) of laminating the first substrate and the second substrate together by direct bonding while making at least a part of the (A-1) metal electrode face the (A-2) metal electrode and making at least a part of the (B-1) resin layer face the (B-2) resin layer, or alternatively while making at least a part of the (A-1) metal electrode face the (A-2) metal electrode and making at least a part of the (B-1) resin layer face the (C) inorganic insulating layer.

As a method of directly bonding the first substrate and the second substrate, wafer to wafer (W2W), which is bonding of wafers using a wafer bonder, chip to wafer (C2W), by which chips are bonded to wafers, or chip to chip (C2C), by which chips are bonded to each other, may be used. Among them, C2W is preferable from the viewpoint of bonding accuracy, ease of circuit design, etc.

For bonding using a chip, a flip chip bonder or the like is used. The chip is obtained through a wafer singulation step by dicing. The C2W laminate can be produced by, for example, preparing a plurality of singulated pieces of a first substrate by dicing, and directly bonding the plurality of pieces of the first substrate on a second substrate side by side. That is, the step (I) includes a singulation step, and in the step (III), a plurality of singulated pieces of the first substrate and a single piece of the second substrate can be laminated together. The method of the dicing is not particularly limited, and examples thereof include blade dicing, laser dicing, and plasma dicing.

Further, after the singulated pieces of the first substrate is bonded to the second substrate, an exposed metal electrode and an exposed resin layer on a face opposite from the bonded face are formed (alternatively, on both faces of the first substrate may be formed in advance an exposed metal electrode and an exposed resin layer), and then may be bonded to another first substrate such that the substrates are vertically arranged. In this way, it is possible to stack a large number of chips at a high density. The plurality of pieces of the first substrate may be the same or different in size.

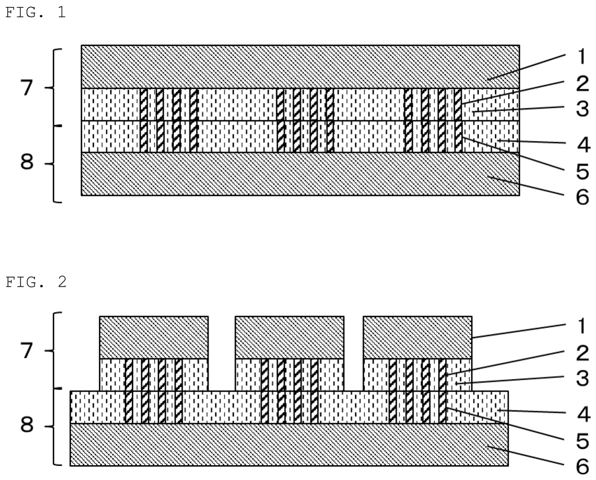

In addition, in the step (III), it is preferable that at the time of laminating the first substrate and the second substrate, the temperature of a lamination stage and the temperature of a bonding head are 20°C or more and 50°C or less. Fig. 1 shows a sectional view of a laminate obtained by W2W, and Fig. 2 shows a sectional view of a laminate obtained by C2W.

After the bonding, it is preferable to perform annealing treatment. By performing the annealing treatment, the bonding strength is enhanced by softening of the resin layer and diffusion of the metal electrode, and the reliability of the resulting laminate is improved. The annealing temperature may be appropriately selected in a range of 100°C or more and 400°C or less, and the annealing time can be selected from 3 minutes to 3 hours according to the purpose. In particular, annealing in the range of 150°C or more and 250°C or less is preferable because the load on the substrate body is small. That is, the method preferably further includes a step of performing annealing treatment at 150°C or more and 250°C or less after the step (III).

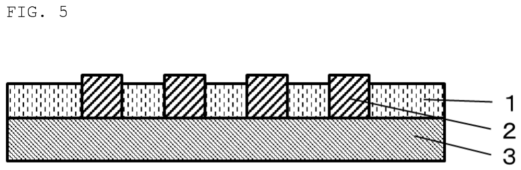

It is preferable that at least one of a step between the (A-1) metal electrode and the (B-1) resin layer included in the first substrate before bonding and a step between the (A-2) metal electrode and the (B-2) resin layer included in the second substrate before bonding is 1 nm or more and 20 nm or less, and the resin layer is lower (this state is called a Cu protrusion). That is, it is preferable that at least one of a step between the (A-1) metal electrode and the (B-1) resin layer of the first substrate after the step (I) and a step between the (A-2) metal electrode and the (B-2) resin layer of the second substrate after the step (II) is 1 nm or more and 20 nm or less, and the resin layer is lower than the metal electrode. In addition, when the second substrate includes the (C) inorganic insulating layer, it is preferable that a step between the (A-1) metal electrode and the (B-1) resin layer included in the first substrate before bonding is 1 nm or more and 20 nm or less, and the resin layer is lower than the metal electrode, that is, there is a Cu protrusion. Owing to this configuration, it is possible to correct a difference in thermal expansion between the (A) metal electrode and the (B) resin layer when heating is performed at the time of bonding or annealing, so that it is possible to improve adhesion and suppress generation of voids. A sectional view of a Cu protrusion (an example of the first substrate) is shown in Fig. 5.

When a photosensitive resin composition is used for the formation of a (B) resin layer, an (A) metal electrode and a (B) resin layer can be formed through a process different from that described above. First, the photosensitive resin composition is applied to a substrate body, dried, exposed to light, developed, and cured to form a (B) resin layer having a pattern. Thereafter, a seed layer of Ti, Ni, or the like is formed by sputtering, a dry film resist is patterned such that the same portions as the openings of the underlying (B) resin layer are opened, and a copper electrode pattern is formed by electrolytic plating. Next, resist removal and seed layer removal are performed to afford a substrate having the exposed (A) metal electrode and the exposed (B) resin layer on the same face. Thereafter, bonding can be performed through the smoothing step and the activation step. Further, since the (A) metal electrode and the (B) resin layer have already been exposed, they may be bonded as they are.

The resin composition of the present invention is a resin composition to be used for at least one resin layer of the (B-1) resin layer and the (B-2) resin layer in a method for producing a laminate including at least the following steps (I), (II) and (III):
step (I): preparing a first substrate including an exposed (A-1) metal electrode and an exposed (B-1) resin layer provided on the same face of a substrate body;
step (II): preparing a second substrate including an exposed (A-2) metal electrode and an exposed (B-2) resin layer, or an exposed (A-2) metal electrode and an exposed (C) inorganic insulating layer provided on the same face of a substrate body;
step (III): laminating the first substrate and the second substrate together by direct bonding while making at least a part of the (A-1) metal electrode face the (A-2) metal electrode and making at least a part of the (B-1) resin layer face the (B-2) resin layer, or alternatively while making at least a part of the (A-1) metal electrode face the (A-2) metal electrode and making at least a part of the (B-1) resin layer face the (C) inorganic insulating layer.

It is preferable with the resin composition of the present invention that the step (III) is a step of laminating the first substrate and the second substrate together by direct bonding while making at least a part of the (A-1) metal electrode and the (A-2) metal electrode face each other and making at least a part of the (B-1) resin layer and the (B-2) resin layer face each other.

The resin composition of the present invention preferably includes a resin which has a group represented by the formula (1) or the formula (2), contains two or more structures represented by formula (9), and contains one or more among polyimides, polyimide precursors, polybenzoxazoles, polybenzoxazole precursors, polyamides excluding the polyimide precursors and the polybenzoxazole precursors, and copolymers thereof, and a solvent,

Preferably, the resin composition of the present invention further contains an antioxidant.

Preferably, the resin composition of the present invention further contains a photoacid generator.

Preferably, the resin composition of the present invention further contains a crosslinking agent.

Note that the specific description of the resin composition of the present invention is the same as the description of the resin composition to be used in the method for producing a laminate of the present invention, and will be omitted.

### EXAMPLES

The present invention will be illustrated below with reference to Examples, but it should be understood that the present invention is not construed as being limited thereto.

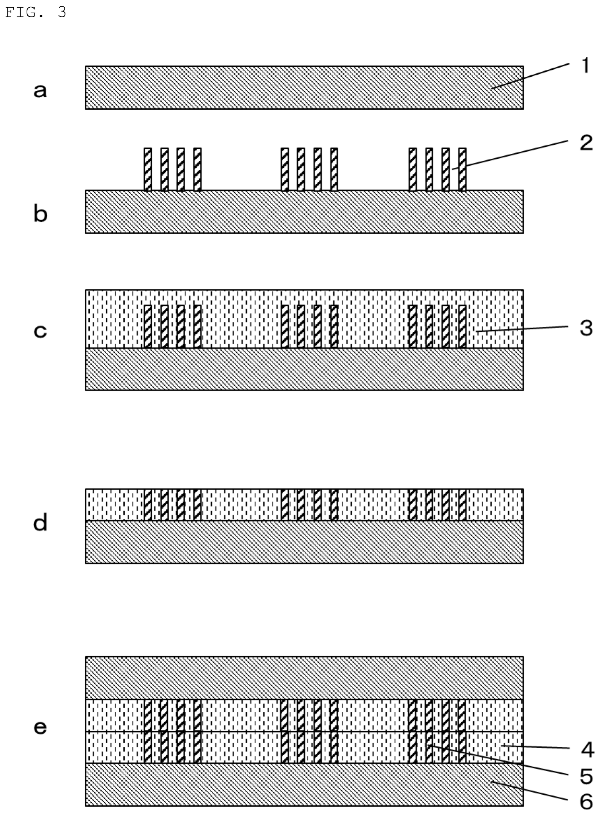

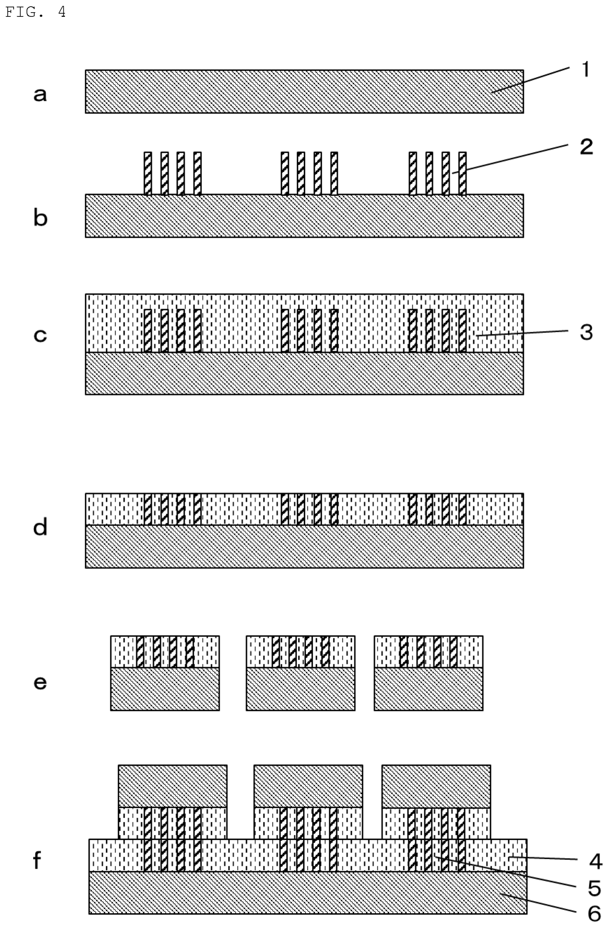

First, a method for preparing a laminate, a method for measuring physical properties of a resin layer will be described. Steps of preparing a laminate are shown in Figs. 3 and 4.

### (1) Preparation of Substrate

### (1-1) Formation of Metal Electrode

A Ti/Cu seed layer was formed on an 8-inch silicon wafer by sputtering, a commercially available dry film resist for plating was laminated, patterning was performed, and via processing (5 rows × 5 columns) with 5 µmφ and a pitch of 10 µm was performed. Thereafter, Cu having a height of 3 µm was formed by electroplating. Thereafter, the resist was removed with a peeling solution, and the seed layer was further removed with an etchant, whereby a Cu pad being 5 µmφ and 3 µm in height was formed on the 8-inch silicon wafer (See Fig. 3-b and Fig. 4-b).

### (1-2) Formation of Resin Layer

The resin composition obtained in the adjustment example described later was spin-coated (1000 rpm, 30 sec) on the wafer with a Cu pad described above, prebaked (at 120°C for 3 minutes), and thermally cured (for 1 hour at an arbitrary temperature (see Table 2), O₂ concentration; 20 vol ppm), affording a resin layer having a thickness of 4 µm (See Fig. 3-c and Fig. 4-c).

### (2) Planarization of Substrate

### (2-1) Surface Planer

The substrate with a Cu pad and a resin layer prepared in (1-2) was subjected to surface grinding treatment using a DAS8930 DISCO Automatic Surface Planer (manufactured by DISCO Corporation) (See Fig. 3-d and Fig. 4-d).

### (2-2) Chemical Mechanical Polishing (CMP)

The substrate with the Cu pad and the resin layer prepared in (1-2) was subjected to CMP treatment using a silica slurry and a urethane polishing pad (See Fig. 3-d and Fig. 4-d).

By the step (2-1) or (2-2), a first substrate and a second substrate each including an exposed (A) metal electrode and an exposed (B) resin layer provided on the same face were obtained.

### (3) Singulation of substrate

The first substrate was singulated (1 mm□) using a DAD3240 Dicing Saw (manufactured by DISCO Corporation) (See Fig. 4-e).

### (4) Activation of Substrate

### (4-1) Activation of Substrate Surface (He Plasma Treatment)

Plasma treatment of the first substrate and the second substrate was performed using an atmospheric plasma system (manufactured by Ontos Equipment System) with 98 vol% of N₂ and 2 vol% of He. The total gas flow rate was set to 15 slpm, the power was set to 80 W, the interval between the substrate faces of the plasma device was set to 1 mm, and the speed of the plasma device was set to 1 mm/sec.

### (4-2) Ar Plasma Treatment

The substrate surface was subjected to plasma treatment using a plasma etching apparatus SPC-100B+H (manufactured by Hitachi High-Tech Instruments Co., Ltd.) under the conditions of Ar gas (flow rate: 40 sccm), pressure: 20 Pa, and power: 150 W.

### (5) Preparation of Laminate

### (5-1) Preparation of W2W Laminate

The first substrate and the second substrate subjected to the plasma treatment in (4) (noted that the first substrate had not been singulated) were W2W bonded at a pressure of 8 MPa and a degree of vacuum of 50 Pa for 3 minutes using a vacuum press VACUUM STAR (manufactured by Mikado Technos Co., Ltd.) with the temperature of the bonding head and the bonding stage being room temperature (23°C), with the faces on which the (A) metal electrode and the (B) resin layer were exposed facing each other (see Fig. 3-e).

### (5-2) Preparation of C2W Laminate

A chip (the first substrate) singulated in (3) and activated in (4) and a wafer (the second substrate) planarized in (2) and activated in (4) were prepared, and the chip was bonded to the wafer at 10 N for 3 seconds using a Flip Lip Bonder FC-3000S (manufactured by Toray Engineering Co., Ltd.) with the temperature of the bonding head and the bonding stage being room temperature (23°C) (see Fig. 4-f).

### (6) Annealing Treatment

The laminate obtained in (5-1) or (5-2) was subjected to annealing treatment at an arbitrary temperature (see Table 3) for 1 hour in a nitrogen atmosphere.

### (7) Measurement of Adhesive Force of Laminate

### (7-1) Measurement of Adhesive Force of W2W Laminate

Using a DAD3240 Dicing Saw (manufactured by DISCO Corporation), only the first substrate part of the laminate prepared in (5-1) was cut such that five singulated chips of 1 mm square would be obtained (the second substrate was kept in the original shape of the substrate). A razor blade was inserted from an end of the laminate, and the first substrate was peeled off from the second substrate such that only the singulated chips would be left. For each chip remaining on the second substrate, a force from the lateral direction was applied to the chip using a die shear analyzer (Series 4000 manufactured by DAGE), and the force applied when the chip was peeled off was measured. The measured value was converted into an adhesive force per unit area by dividing the measured value by the area of the chip, and the average value of five resulting values was taken as the adhesive force of the W2W laminate. Furthermore, the same sample was subjected to PCT treatment for 100 hours under conditions of 121°C, 2 atm, and RH100% using a pressure cooker test (PCT) apparatus (HAST CHAMBER EHS-211MD manufactured by Tabai Espec Corp.), and subsequently subjected to a die shear test.

### (7-2) Measurement of Adhesive Force of C2W Laminate

For each of the five chips (pieces of the first substrate) in the C2W laminate prepared in (4-1) or (4-2), a force from the lateral direction was applied to the chip using a die shear analyzer (Series 4000 manufactured by DAGE), and the force applied when the chip was peeled off was measured. The measured value was converted into an adhesive force per unit area by dividing the measured value by the area of the chip, and the average value of five resulting values was taken as the adhesive force of the C2W laminate. Furthermore, the same sample was subjected to PCT treatment for 100 hours under conditions of 121°C, 2 atm, and RH100% using a pressure cooker test (PCT) apparatus (HAST CHAMBER EHS-211MD manufactured by Tabai Espec Corp.), and subsequently subjected to a die shear test.

### (8) Observation of Voids

The laminate obtained in (5) or (6) was observed for the presence or absence of voids using an ultrasonic microscope, and the void area was measured. A void area of 0% was rated as 4, a void area of more than 0% and less than 2% was rated as 3, a void area of 2% or more and less than 5% was rated as 2, a void area of 5% or more was rated as 1, and the rating of 2 more was regarded as acceptable.

### (9) Measurement of Metal Electrode-Resin Layer Step

The first substrate or the second substrate after flattening obtained in (2) was subjected to surface observation using an atomic force microscope, and the step between the (A) metal electrode and the (B) resin layer was measured. A case where the (A) metal electrode was high was defined as a positive value, and a case where the (A) metal electrode was low was defined as a negative value.

### (10) Test of Laminate Reliability

### (10-1) High Temperature Storage (HTS) Test

The laminate prepared in (6) was treated at 175°C for 200 hours using a hot air oven.

The laminate after the treatment was sectionally cut with an ion milling system (IM4000 manufactured by Hitachi High-Technologies Corporation), followed by sectional observation with a scanning electron microscope (SEM, S-3000N manufactured by Hitachi High-Technologies Corporation), whereby the condition of the occurrence of peeling was confirmed. As an evaluation method, the degree of peeling of the metal electrode was observed, and where peeling 0% was rated as 4, peeling more than 0% and less than 25% was rated as 3, peeling 25% or more and less than 50% was rated as 2, and peeling 50% or more was rated as 1, and the rating of 2 or more was regarded as acceptable.

### (10-2) Thermal Cycle (TC) Test

The laminate prepared in (6) was subjected to 500 cycles of treatment at -45°C for 15 minutes and at 125°C for 15 minutes per cycle using a thermal cycle tester (hereinafter referred to as "TC apparatus") (manufactured by Tabai Espec Corp.).

The laminate after the treatment was sectionally cut with an ion milling apparatus, followed by sectional observation with a scanning electron microscope, whereby the condition of the occurrence of cracks was confirmed. As an evaluation method, the degree of cracks in the resin layer was observed, and where the occurrence of 0 cracks was rated as 4, the occurrence of 1 to 3 cracks was rated as 3, the occurrence of 4 to 10 cracks was rated as 2, and the occurrence of 11 or more cracks was rated as 1, and the rating of 2 or more was regarded as acceptable.

### (11) Measurement of Elastic Modulus

A resin composition was applied onto a 6-inch silicon wafer by a spin coating method and prebaked using a coater and developer Mark-7 such that the film thickness after prebaking at 120°C for 3 minutes was 5 µm. Then, when the resin composition used was a resin composition containing a photosensitive component (photoacid generator), the entire surface of the prebaked product was exposed to light at 300 mJ/cm² using a PLA, and the temperature was raised to 220°C at 3.5°C/min at an oxygen concentration of 20 ppm or less using an inert oven CLH-21CD-S (manufactured by Koyo Thermo Systems Co., Ltd.), and heat treatment was performed for 1 hour. when the resin composition used was a resin composition containing no photosensitive component, the prebaked product as received was subjected to that raising of the temperature and the subsequent heat treatment. The heat cured wafer was cut into a size of 5 cm square, and the elastic modulus was measured using a nanoindenter (Triboindenter TI 950 manufactured by Hysitron, Inc.). The obtained value was taken as the elastic modulus of the resin layer.

### (12) Measurement of Coefficient of Thermal Expansion (CTE)

A resin composition was applied onto a 6-inch silicon wafer by a spin coating method and prebaked using a coater and developer Mark-7 such that the film thickness after prebaking at 120°C for 3 minutes was 10 µm. Then, when the resin composition used was a resin composition containing a photosensitive component (photoacid generator), the entire surface of the prebaked product was exposed to light at 300 mJ/cm² using a PLA, and the temperature was raised to 220°C at 3.5°C/min at an oxygen concentration of 20 ppm or less using an inert oven CLH-21CD-S (manufactured by Koyo Thermo Systems Co., Ltd.), and heat treatment was performed for 1 hour. when the resin composition used was a resin composition containing no photosensitive component, the prebaked product as received was subjected to that raising of the temperature and the subsequent heat treatment. When the temperature reached 50°C or less, the wafer was taken out and immersed in 45% by mass of hydrofluoric acid for 1 minutes, whereby the cured film was peeled off from the wafer. This film was cut into a strip shape having a width of 1.5 cm and a length of 3 cm, and measurement was performed using a thermomechanical analyzer (EXSTAR 6000TMA/SS6000 manufactured by SII NanoTechnology Inc.). In the first stage, the temperature of the sample was raised to 150°C at a rate of temperature rise of 5°C/min to remove adsorbed water from the sample, and in the second stage, the sample was air cooled to room temperature at a rate of temperature fall of 5°C/min. In the third stage, the main measurement was performed at a rate of temperature rise of 5°C/min. As the coefficient of thermal expansion of the intended polyimide film, an average value in the temperature range of 50°C to 150°C in this measurement was determined. From the value of the coefficient of thermal expansion, the following determinations of A, B, and C were made, and A was determined to be good, B was determined to be tolerable, and C was determined to be bad.
A: The coefficient of thermal expansion is 20 ppm/K or more and less than 25 ppm/K.
B: The coefficient of linear expansion is 10 ppm/K or more and less than 20 ppm/K, or 25 ppm/K or more and 40 ppm/K or less.
C: The coefficient of linear expansion is less than 10 ppm/K and more than 40 ppm/K.

Next, a resin composition to be used for forming the (B) resin layer will be described. All the resin compositions obtained were each filtered through a 1 µm polytetrafluoroethylene filter (manufactured by Sumitomo Electric Industries, Ltd.) before evaluation.

Hereinafter, abbreviations of compounds used in the synthesis examples and the examples will be described.
SiDA: 1,3-bis(3-aminopropyl)tetramethyldisiloxane
BAHF: 2,2-bis(3-amino-4-hydroxyphenyl)hexafluoropropane
PDA: p-phenylenediamine
ODPA: 3,3',4,4'-diphenyl ether tetracarboxylic acid dianhydride
PMDA: pyromellitic dianhydride
BPDA: 3,3',4,4'-biphenyltetracarboxylic acid dianhydride
DFA: dimethylformamide dimethyl acetal
HA: 2,2-bis[3-(3-aminobenzamido)-4-hydroxyphenyl]hexafluoropropane
NA: 5-norbornene-2,3-dicarboxylic anhydride
MAP: m-aminophenol
ODA: 4,4'-diaminodiphenyl ether
m-TB: 2,2'-dimethyl-4,4'-diaminobiphenyl
RT-1000: diamine containing structure of formula (1) (trade name, manufactured by HUNTSMAN Corporation)
KF-8010: diamine containing structure of formula (2) (trade name, manufactured by Shin-Etsu Chemical Co., Ltd.)
Dicarboxylic acid derivative A: 1,1'-(4,4'-oxybenzoyl)diimidazole
Dicarboxylic acid derivative B: 1,12-bis(1-imidazole)-1,12-dodecanedione
NMP: N-methyl-2-pyrrolidone
GBL: γ-butyrolactone
CHN: cyclohexanone
MOM: 4-[1,1-bis[4-hydroxy-3,5-bis(methoxymethyl)phenyl]ethyl]-2,6-bis(methoxymethyl)phenol (crosslinking agent)
TP5-280M: 5-Naphthoquinonediazidesulfonic acid ester compound of α,α,α-tris(4-hydroxyphenyl)-1-ethyl-4-isopropylbenzene (photoacid generator) (trade name, manufactured by Toyo Gosei Co., Ltd.)
IRGANOX245: Ethylenebis(oxyethylene) bis(3-(5-tert-butyl-4-hydroxy-m-tolyl)propionate) (antioxidant) (trade name: manufactured by BASF)

### [Synthesis Example 1] Synthesis of polyimide (P-1)

Under a dry nitrogen stream, 29.30 g (0.080 mol) of BAHF, 10.00 g of RT-1000, 2.18 g (0.020 mol) of MAP, and 190 g of NMP were weighed and dissolved in a three-necked flask. To this was added a solution in which 31.02 g (0.10 mol; 100 mol% relative to the structural unit derived from all of carboxylic acids and derivatives thereof) of ODPA was dissolved in 100 g of NMP. The resultant mixture was stirred at 20°C for 1 hour, and then further stirred at 50°C for 4 hours. Thereafter, 15 g of xylene was added to the solution, and the resultant solution was stirred at 150°C for 5 hours while azeotropically distilling water together with xylene. After the completion of the reaction, the reaction solution was introduced into 3 L of water, and the solid precipitate having deposited was collected by filtration. The obtained solid material was washed with water three times and was then dried with a vacuum dryer at 80°C for 24 hours to produce polyimide (P-1).

### [Synthesis Example 2] Synthesis of polyimide (P-2)

Under a dry nitrogen stream, 29.30 g (0.080 mol) of BAHF, 8.6 g of KF-8010, 2.18 g (0.020 mol) of MAP, and 100 g of CHN were weighed and dissolved in a three-necked flask. To this was added 31.02 g (0.10 mol; 100 mol% relative to the structural unit derived from all of carboxylic acids and derivatives thereof) of ODPA together with 50 g of CHN. The resultant mixture was stirred at 20°C for 1 hour, and then further stirred at 50°C for 4 hours. Thereafter, the mixture was stirred at 150°C for 5 hours while azeotropically boiling water together with cyclohexanone, thereby affording polyimide (P-2).

### [Synthesis Example 3] Synthesis of polyimide precursor (P-3)

Under a dry nitrogen stream, 51.4 g (0.085 mol) of HA, 1.24 g (0.005 mol) of SiDA, and 2.18 g (0.020 mol) of MAP as an end-capping agent were dissolved in 200 g of NMP. To the obtained solution, 31.0 g (0.10 mol) of ODPA was added, and the resulting mixture was stirred at 40°C for 2 hours. Thereafter, a solution prepared by diluting 7.14 g (0.06 mol) of DFA with 5 g of NMP was added dropwise over 10 minutes. After completion of the dropwise addition, stirring was continuously conducted at 40°C for 2 hours. After the completion of the stirring, the solution was put into 2 L of water, and the polymer solid precipitate was collected by filtration. Following further washing three times with 2 L of water, the collected polymer solid was dried in a vacuum dryer at 50°C for 72 hours, affording polyimide precursor (P-3).

### [Synthesis Example 4] Synthesis of polybenzoxazole precursor (P-4)

Under a dry nitrogen stream, BAHF (34.79 g (0.095 mol)) and SiDA (1.24 g) were dissolved in NMP (200 g). To this solution, 28.67 g (0.080 mol) of the dicarboxylic acid derivative A was added together with 20 g of NMP, and the resulting mixture was made to react at 85°C for 3 hours. Subsequently, 6.57 g (0.040 mol) of NA was added together with 10 g of NMP, and the resulting mixture was made to react at 85°C for 30 minutes. After the completion of the reaction, the mixture was cooled to room temperature, 48.02 g (0.80 mol) of acetic acid was added together with 90 g of NMP, and the resulting mixture was stirred at room temperature for 1 hour. After the completion of the stirring, the solution was poured into 3 L of water, affording a white precipitate. The precipitate was collected by filtration, washed with water three times, and then dried in a vacuum dryer at 50°C for 3 days, affording a powder of polybenzoxazole precursor (P-4).

### [Synthesis Example 5] Synthesis of Polybenzoxazole Precursor/Polyamide Copolymer (P-5)

Under a dry nitrogen stream, 32.96 g (0.090 mol) of BAHF and 10.00 g (0.010 mol) of RT-1000 were dissolved in 200 g of NMP. To this solution, 32.25 g (0.090 mol) of the dicarboxylic acid derivative A was added together with 20 g of NMP, and the resulting mixture was made to react at 85°C for 3 hours. Subsequently, 3.28 g (0.020 mol) of NA was added together with 10 g of NMP, and the resulting mixture was made to react at 85°C for 30 minutes. After the completion of the reaction, the mixture was cooled to room temperature, 54.02 g (0.90 mol) of acetic acid was added together with 90 g of NMP, and the resulting mixture was stirred at room temperature for 1 hour. After the completion of the stirring, the solution was poured into 3 L of water, affording a white precipitate. The precipitate was collected by filtration, washed with water 3 times, and then dried in a vacuum dryer at 50°C for 3 days, affording a powder of polybenzoxazole precursor/polyamide copolymer (P-5).

### [Synthesis Example 6] Synthesis of polybenzoxazole precursor/polyimide precursor copolymer (P-6)

Under a dry nitrogen stream, 32.96 g (0.090 mol) of BAHF and 10.00 g (0.010 mol) of RT-1000 were dissolved in 200 g of NMP. To this solution, 30.46 g (0.085 mol) of the dicarboxylic acid derivative A was added together with 20 g of NMP, and the resulting mixture was made to react at 85°C for 3 hours. Subsequently, 1.24 g (0.005 mol) of SiDA, 1.55 g (0.005 mol) of ODPA, and 4.92 g (0.030 mol) of NA were added together with 20 g of NMP, and the mixture was made to react at 85°C for 30 minutes. After the completion of the reaction, the mixture was cooled to room temperature, 51.02 g (0.85 mol) of acetic acid was added together with 90 g of NMP, and the resulting mixture was stirred at room temperature for 1 hour. After the completion of the stirring, the solution was poured into 3 L of water, affording a white precipitate. The precipitate was collected by filtration, washed with water three times, and then dried in a vacuum dryer at 50°C for 3 days, affording a powder of polybenzoxazole precursor/polyimide precursor copolymer (P-6).

### [Synthesis Example 7] Synthesis of Polybenzoxazole Precursor/Polyimide Precursor Copolymer (P-7)

Under a dry nitrogen stream, 32.96 g (0.090 mol) of BAHF and 10.00 g (0.010 mol) of RT-1000 were dissolved in 200 g of NMP. To this solution, 16.13 g (0.045 mol) of the dicarboxylic acid derivative A and 13.22 g (0.040 mol) of the dicarboxylic acid derivative B were added together with 20 g of NMP, and the resulting mixture was made to react at 85°C for 3 hours. Subsequently, 1.24 g (0.005 mol) of SiDA, 1.55 g (0.005 mol) of ODPA, and 4.92 g (0.030 mol) of NA were added together with 20 g of NMP, and the mixture was made to react at 85°C for 30 minutes. After the completion of the reaction, the mixture was cooled to room temperature, 51.02 g (0.85 mol) of acetic acid was added together with 90 g of NMP, and the resulting mixture was stirred at room temperature for 1 hour. After the completion of the stirring, the solution was poured into 3 L of water, affording a white precipitate. The precipitate was collected by filtration, washed with water three times, and then dried in a vacuum dryer at 50°C for 3 days, affording a powder of polybenzoxazole precursor/polyimide precursor copolymer (P-7).

### [Synthesis Example 8] Polyimide Precursor (P-8)

Under a dry nitrogen stream, 19.2 g (0.096 mol) of ODA and 0.99 g (0.004 mol) of SiDA were dissolved in 200 g of NMP. To this solution, 16.8 g (0.077 mol) of PMDA and 5.9 g (0.020 mol) of BPDA were added, and the resulting mixture was stirred at 60°C for 5 hours, affording polyimide precursor solution (P-8). After stirring, NMP was added such that the solid concentration was 16 wt%.

### [Synthesis Example 9] Polyimide Precursor (P-9)

Under a dry nitrogen stream, 10.4 g (0.096 mol) of PDA and 0.99 g (0.004 mol) of SiDA were dissolved in 200 g of NMP. To this solution, 28.5 g (0.097 mol) of BPDA was added, and the resulting mixture was stirred at 60°C for 5 hours, affording polyimide precursor solution (P-9). After stirring, NMP was added such that the solid concentration was 16 wt%.

### [Synthesis Example 10] Polyimide Precursor (P-10)

Under a dry nitrogen stream, 7.8 g (0.072 mol) of PDA, 4.8 g (0.024 mol) of ODA, and 0.99 g (0.004 mol) of SiDA were dissolved in 200 g of NMP. To this solution, 28.5 g (0.097 mol) of BPDA was added, and the resulting mixture was stirred at 60°C for 5 hours, affording polyimide precursor solution (P-10). After stirring, NMP was added such that the solid concentration was 16 wt%.

### [Synthesis Example 11] Polyimide Precursor (P-11)

Under a dry nitrogen stream, 20.4 g (0.096 mol) of m-TB and 0.99 g (0.004 mol) of SiDA were dissolved in 200 g of NMP. To this solution, 28.5 g (0.097 mol) of BPDA was added, and the resulting mixture was stirred at 60°C for 5 hours, affording polyimide precursor solution (P-11). After stirring, NMP was added such that the solid concentration was 16 wt%.

### [Comparative Synthesis Example 1] Synthesis of Polyimide Precursor (HP-1)

Under a dry nitrogen stream, 18.02 g (0.090 mol) of ODA was dissolved in 160 g of NMP. To the resulting solution, 21.81 g (0.10 mol) of ODPA was added, and the resulting mixture was stirred at 40°C for 2 hours, affording a 20 wt% solution of polyimide precursor (HP-1) in NMP.

### [Comparative Synthesis Example 2] Synthesis of Polyimide Precursor (HP-2)

Under a dry nitrogen stream, 10.6 g (0.098 mol) of PDA was dissolved in 160 g of NMP. To the resulting solution, 11.77 g (0.04 mol) of BDPA and 13.09 g (0.04 mol) of PMDA were added, and the resulting mixture was stirred at 40°C for 2 hours, affording a 20 wt% solution of polyimide precursor (HP-2) in NMP.

### [Adjustment Examples 1 to 15 and Comparative Adjustment Examples 1 to 2]

A resin obtained in Synthesis Example or Comparative Synthesis Example or a ready-made resin was mixed with a solvent and an additive such that the weight ratio and the solid concentration shown in Table 1 were attained, affording each resin composition.

**[Table 1]**

| | Resin composition | Resin | Specific structure in resin | parts by weight | Additive 1 | parts by weight | Additive 2 | parts by weight | Additive 3 | parts by weight | Solvent | Solid concentration |
|---|---|---|---|---|---|---|---|---|---|---|---|---|
| Adjustment Example 1 | V-1 | P-1 | Formula (1) | 100 | | | | | | | GBL | 20 wt% |
| Adjustment Example 2 | V-2 | P-2 | Formula (2) | 100 | | | | | | | CHN | 20 wt% |
| Adjustment Example 3 | V-3 | P-3 | Formula (2) | 100 | | | | | | | GBL | 20 wt% |
| Adjustment Example 4 | V-4 | P-4 | Formula (2) | 100 | | | | | | | GBL | 20 wt% |
| Adjustment Example 5 | V-5 | P-5 | Formula (1) | 100 | | | | | | | GBL | 20 wt% |
| Adjustment Example 6 | V-6 | P-6 | Formula (1), formula (2) | 100 | | | | | | | GBL | 20 wt% |
| Adjustment Example 7 | V-7 | P-7 | Formula (1), formula (2) | 100 | | | | | | | GBL | 20 wt% |
| Adjustment Example 8 | V-8 | P-7 | Formula (1), formula (2) | 100 | IRGANOX245 | 3 | | | | | GBL | 20 wt% |
| Adjustment Example 9 | V-9 | P-7 | Formula (1), formula (2) | 100 | IRGANOX245 | 3 | MOM | 10 | | | GBL | 20 wt% |
| Adjustment Example 10 | V-10 | P-7 | Formula (1), formula (2) | 100 | IRGANOX245 | 3 | MOM | 10 | TP5-280M | 15 | GBL | 20 wt% |
| Adjustment Example 11 | V-11 | P-3 | Formula (2) | 100 | IRGANOX245 | 3 | MOM | 10 | TP5-280M | 15 | GBL | 20 wt% |
| Adjustment Example 12 | V-12 | P-8 | Formula (2), formula (9) | 100 | IRGANOX245 | 3 | | | | | NMP | 16 wt% |
| Adjustment Example 13 | V-13 | P-9 | Formula (2), formula (9) | 100 | IRGANOX245 | 3 | | | | | NMP | 16 wt% |
| Adjustment Example 14 | V-14 | P-10 | Formula (2), formula (9) | 100 | IRGANOX245 | 3 | | | | | NMP | 16 wt% |
| Adjustment Example 15 | V-15 | P-11 | Formula (2), formula (9) | 100 | IRGANOX245 | 3 | | | | | NMP | 16 wt% |
| Comparative Adjustment Example 1 | HV-1 | HP-1 | | 100 | | | | | | | NMP | 20 wt% |
| Comparative Adjustment Example 2 | HV-2 | HP-2 | | 100 | | | | | | | NMP | 20 wt% |

### [Examples 1 to 50, Comparative Examples 1 to 6]

Using the resin compositions prepared in Adjustment Examples and the commercially available resin compositions, laminates were prepared by the laminate preparation method described above, and the evaluation the laminates was performed. In addition, the elastic modulus of the cured films of the resin compositions was measured. These Examples and Comparative Examples are shown in Table 2 to Table 4. The coefficient of thermal expansion (CTE) was measured for Preparation Examples 12 to 15 and Comparative Preparation Example 2. The results are shown in Table 5.

**[Table 2-1]**

| | Substrate configuration | | | | | | | |
|---|---|---|---|---|---|---|---|---|
| | First substrate | | | | Second substrate | | | |
| | (A-1) Metal electrode | (B-1) Resin layer | | | (A-2) Metal electrode | (B-2) Resin layer | | |
| | | Compos ition | Elastic modulus (GPa) | Curing temperature (°C) | | Compos ition | Elastic modulus (GPa) | Curing temperature (°C) |
| Example 1 | Cu | V-1 | 2.9 | 230 | Cu | V-1 | 2.9 | 230 |
| Example 2 | Cu | V-2 | 1.0 | 230 | Cu | V-2 | 1.0 | 230 |
| Example 3 | Cu | V-3 | 4.1 | 300 | Cu | V-3 | 4.1 | 300 |
| Example 4 | Cu | V-4 | 3.7 | 230 | Cu | V-4 | 3.7 | 230 |
| Example 5 | Cu | V-5 | 3.4 | 230 | Cu | V-5 | 3.4 | 230 |
| Example 6 | Cu | V-6 | 3.3 | 230 | Cu | V-6 | 3.3 | 230 |
| Example 7 | Cu | V-7 | 3.2 | 230 | Cu | V-7 | 3.2 | 230 |
| Example 8 | Cu | V-8 | 3.2 | 230 | Cu | V-8 | 3.2 | 230 |
| Example 9 | Cu | V-9 | 4.0 | 230 | Cu | V-9 | 4.0 | 230 |
| Example 10 | Cu | V-10 | 4.3 | 230 | Cu | V-10 | 4.3 | 230 |
| Example 11 | Cu | V-11 | 5.9 | 300 | Cu | V-11 | 5.9 | 300 |
| Example 12 | Cu | V-10 | 4.3 | 230 | Cu | V-10 | 4.3 | 230 |
| Example 13 | Cu | V-10 | 4.3 | 230 | Cu | V-10 | 4.3 | 230 |
| Example 14 | Cu | V-10 | 4.3 | 230 | Cu | V-10 | 4.3 | 230 |
| Example 15 | Cu | V-10 | 4.3 | 230 | Cu | V-10 | 4.3 | 230 |
| Example 16 | Cu | V-10 | 4.3 | 230 | Cu | V-10 | 4.3 | 230 |
| Example 17 | Cu | V-10 | 4.3 | 230 | Cu | V-10 | 4.3 | 230 |
| Example 18 | Cu | V-10 | 4.3 | 230 | Cu | V-10 | 4.3 | 230 |
| Example 19 | Cu | V-1 | 2.9 | 230 | Cu | V-1 | 2.9 | 230 |
| Example 20 | Cu | V-2 | 1.5 | 230 | Cu | V-2 | 1.5 | 230 |
| Example 21 | Cu | V-3 | 4.1 | 300 | Cu | V-3 | 4.1 | 300 |
| Example 22 | Cu | V-4 | 3.7 | 230 | Cu | V-4 | 3.7 | 230 |
| Example 23 | Cu | V-5 | 3.4 | 230 | Cu | V-5 | 3.4 | 230 |
| Example 24 | Cu | V-6 | 3.3 | 230 | Cu | V-6 | 3.3 | 230 |
| Example 25 | Cu | V-7 | 3.2 | 230 | Cu | V-7 | 3.2 | 230 |
| Example 26 | Cu | V-8 | 3.2 | 230 | Cu | V-8 | 3.2 | 230 |
| Example 27 | Cu | V-9 | 4.0 | 230 | Cu | V-9 | 4.0 | 230 |
| Example 28 | Cu | V-10 | 4.3 | 230 | Cu | V-10 | 4.3 | 230 |
| Example 29 | Cu | V-11 | 5.9 | 300 | Cu | V-11 | 5.9 | 300 |
| Example 30 | Cu | V-10 | 4.3 | 230 | Cu | V-10 | 4.3 | 230 |
| Example 31 | Cu | V-10 | 4.3 | 230 | Cu | V-10 | 4.3 | 230 |
| Example 32 | Cu | V-10 | 4.3 | 230 | Cu | V-10 | 4.3 | 230 |
| Example 33 | Cu | V-10 | 4.3 | 230 | Cu | V-10 | 4.3 | 230 |
| Example 34 | Cu | V-10 | 4.3 | 230 | Cu | V-10 | 4.3 | 230 |
| Example 35 | Cu | V-10 | 4.3 | 230 | Cu | V-10 | 4.3 | 230 |
| Example 36 | Cu | V-10 | 4.3 | 230 | Cu | V-10 | 4.3 | 230 |

**[Table 2-2]**

| | Substrate configuration | | | | | | | |
|---|---|---|---|---|---|---|---|---|
| | First substrate | | | | Second substrate | | | |
| | (A-1) Metal electr ode | (B-1) Resin layer | | | (A-2) Metal electr ode | (B-2) Resin layer | | |
| | | Composit ion | Elastic modulus (GPa) | Curing temperature (°C) | | Composit ion | Elastic modulus (GPa) | Curing temperature (°C) |
| Example 37 | Cu | V-10 | 4.3 | 230 | Cu | SiO₂*¹ | - | - |
| Example 38 | Cu | V-10 | 4.3 | 230 | Cu | SiO₂*¹ | - | - |
| Example 39 | Cu | V-14 | 6.9 | 300 | Cu | SiO₂*¹ | - | - |
| Example 40 | Cu | V-12 | 5.1 | 300 | Cu | V-12 | 5.1 | 300 |
| Example 41 | Cu | V-13 | 6.9 | 300 | Cu | V-13 | 6.9 | 300 |
| Example 42 | Cu | V-14 | 5.4 | 300 | Cu | V-14 | 5.4 | 300 |
| Example 43 | Cu | V-15 | 6.1 | 300 | Cu | V-15 | 6.1 | 300 |
| Example 44 | Cu | V-10 | 4.3 | 230 | Cu | SiO₂*¹ | - | - |
| Example 45 | Cu | V-10 | 4.3 | 230 | Cu | SiO₂*¹ | - | - |
| Example 46 | Cu | V-14 | 6.9 | 300 | Cu | SiO₂*¹ | - | - |
| Example 47 | Cu | V-12 | 5.1 | 300 | Cu | V-12 | 5.1 | 300 |
| Example 48 | Cu | V-13 | 6.9 | 300 | Cu | V-13 | 6.9 | 300 |
| Example 49 | Cu | V-14 | 5.4 | 300 | Cu | V-14 | 5.4 | 300 |
| Example 50 | Cu | V-15 | 6.1 | 300 | Cu | V-15 | 6.1 | 300 |
| Comparative Example 1 | Cu | HV-1 | 4.5 | 300 | Cu | HV-1 | 4.5 | 300 |
| Comparative Example 2 | Cu | HV-2 | 5.8 | 300 | Cu | HV-2 | 5.8 | 300 |
| Comparative Example 3 | Cu | - (SiO₂*²) | - | - | Cu | - (SiO₂*²) | - | - |
| Comparative Example 4 | Cu | HV-1 | 4.5 | 300 | Cu | HV-1 | 4.5 | 300 |
| Comparative Example 5 | Cu | HV-2 | 5.8 | 300 | Cu | HV-2 | 5.8 | 300 |
| Comparative Example 6 | Cu | - (SiO₂*²) | - | - | Cu | - (SiO₂*²) | - | - |

| | | | | | | | | |
|---|---|---|---|---|---|---|---|---|
| *1: As (C) inorganic insulating layer *2: Instead of resin layer | | | | | | | | |

**[Table 3-1]**

| | Laminate production process | | | | | | | |
|---|---|---|---|---|---|---|---|---|
| | Laminate configuration | Planarization Step | | Activation step | | Bonding step | | |
| | | First substrate | Second substrate | First substrate | Second substrate | Pressure | Temperature (Head) | Temperature (Stage) |
| Example 1 | W2W | CMP | CMP | He plasma | He plasma | 8 MPa | 23°C | 23°C |
| Example 2 | W2W | CMP | CMP | He plasma | He plasma | 8 MPa | 23°C | 23°C |
| Example 3 | W2W | CMP | CMP | He plasma | He plasma | 8 MPa | 23°C | 23°C |
| Example 4 | W2W | CMP | CMP | He plasma | He plasma | 8 MPa | 23°C | 23°C |
| Example 5 | W2W | CMP | CMP | He plasma | He plasma | 8 MPa | 23°C | 23°C |
| Example 6 | W2W | CMP | CMP | He plasma | He plasma | 8 MPa | 23°C | 23°C |
| Example 7 | W2W | CMP | CMP | He plasma | He plasma | 8 MPa | 23°C | 23°C |
| Example 8 | W2W | CMP | CMP | He plasma | He plasma | 8 MPa | 23°C | 23°C |
| Example 9 | W2W | CMP | CMP | He plasma | He plasma | 8 MPa | 23°C | 23°C |
| Example 10 | W2W | CMP | CMP | He plasma | He plasma | 8 MPa | 23°C | 23°C |
| Example 11 | W2W | CMP | CMP | He plasma | He plasma | 8 MPa | 23°C | 23°C |
| Example 12 | W2W | Surface planer | Surface planer | He plasma | He plasma | 8 MPa | 23°C | 23°C |
| Example 13 | W2W | Surface planer | CMP | He plasma | He plasma | 8 MPa | 23°C | 23°C |
| Example 14 | W2W | CMP | CMP | Ar plasma | Ar plasma | 8 MPa | 23°C | 23°C |

**[Table 3-2]**

| | Laminate production process | | | | | | | |
|---|---|---|---|---|---|---|---|---|
| | Laminate configuration | Planarization Step | | Activation step | | Bonding step | | |
| | | First substrate | Second substrate | First substrate | Second substrate | Pressure | Temperature (Head) | Temperature (Stage) |
| Example 15 | W2W | CMP | CMP | He plasma | He plasma | 8 MPa | 23°C | 23°C |
| Example 16 | W2W | CMP | CMP | He plasma | He plasma | 8 MPa | 23°C | 23°C |
| Example 17 | W2W | CMP | CMP | He plasma | He plasma | 8 MPa | 100°C | 100°C |
| Example 18 | W2W | CMP | CMP | He plasma | He plasma | 8 MPa | 23°C | 23°C |
| Example 37 | W2W | CMP | CMP | He plasma | He plasma | 8 MPa | 23°C | 23°C |
| Example 38 | W2W | CMP | CMP | He plasma | He plasma | 8 MPa | 23°C | 23°C |
| Example 39 | W2W | CMP | CMP | He plasma | He plasma | 8 MPa | 23°C | 23°C |
| Example 40 | W2W | CMP | CMP | He plasma | He plasma | 8 MPa | 23°C | 23°C |
| Example 41 | W2W | CMP | CMP | He plasma | He plasma | 8 MPa | 23°C | 23°C |
| Example 42 | W2W | CMP | CMP | He plasma | He plasma | 8 MPa | 23°C | 23°C |
| Example 43 | W2W | CMP | CMP | He plasma | He plasma | 8 MPa | 23°C | 23°C |
| Comparative Example 1 | W2W | CMP | CMP | He plasma | He plasma | 8 MPa | 23°C | 23°C |
| Comparative Example 2 | W2W | CMP | CMP | He plasma | He plasma | 8 MPa | 23°C | 23°C |
| Comparative Example 3 | W2W | CMP | CMP | He plasma | He plasma | 8 MPa | 23°C | 23°C |

**[Table 3-3]**

| | Laminate production process | | | Evaluation results of laminate | | | | |
|---|---|---|---|---|---|---|---|---|
| | Anneal | Electrode-resin layer step | | Void area | Adhesive force (MPa) | | Reliability test | |
| | Temperature | First substrate | Second substrate | | After annealing | After PCT | HTS | TC |
| Example 1 | 250°C | 0 nm | 0 nm | 4 | 25 | 22 | 3 | 4 |
| Example 2 | 250°C | 0 nm | 0 nm | 4 | 25 | 22 | 2 | 4 |
| Example 3 | 250°C | 0 nm | 0 nm | 4 | 15 | 12 | 3 | 3 |
| Example 4 | 250°C | 0 nm | 0 nm | 4 | 15 | 12 | 3 | 3 |
| Example 5 | 250°C | 0 nm | 0 nm | 4 | 25 | 21 | 3 | 4 |
| Example 6 | 250°C | 0 nm | 0 nm | 4 | 25 | 21 | 3 | 4 |
| Example 7 | 250°C | 0 nm | 0 nm | 4 | 30 | 25 | 3 | 4 |
| Example 8 | 250°C | 0 nm | 0 nm | 4 | 30 | 27 | 4 | 4 |
| Example 9 | 250°C | 0 nm | 0 nm | 4 | 33 | 31 | 4 | 4 |
| Example 10 | 250°C | 0 nm | 0 nm | 4 | 35 | 33 | 4 | 4 |
| Example 11 | 250°C | 0 nm | 0 nm | 4 | 20 | 18 | 4 | 4 |
| Example 12 | 250°C | 0 nm | 0 nm | 4 | 15 | 12 | 4 | 4 |
| Example 13 | 250°C | 0 nm | 0 nm | 4 | 17 | 14 | 4 | 4 |
| Example 14 | 250°C | 0 nm | 0 nm | 4 | 25 | 21 | 4 | 4 |

**[Table 3-4]**

| | Laminate production process | | | Evaluation results of laminate | | | | |
|---|---|---|---|---|---|---|---|---|
| | Anneal | Electrode-resin layer step | | Void area | Adhesive force (MPa) | | Reliability test | |
| | Temperature | First substrate | Second substrate | | After annealing | After PCT | HTS | TC |
| Example 15 | 250°C | 5 nm | 0 nm | 4 | 37 | 34 | 4 | 4 |
| Example 16 | 250°C | 5 nm | 5 nm | 4 | 39 | 35 | 4 | 4 |
| Example 17 | 250°C | 0 nm | 0 nm | 4 | 25 | 21 | 3 | 3 |
| Example 18 | 300°C | 0 nm | 0 nm | 4 | 25 | 21 | 4 | 4 |
| Example 37 | 250°C | 0 nm | 0 nm | 4 | 34 | 30 | 4 | 4 |
| Example 38 | 250°C | 5 nm | 0 nm | 4 | 36 | 31 | 4 | 4 |
| Example 39 | 250°C | 0 nm | 0 nm | 4 | 22 | 19 | 4 | 4 |
| Example 40 | 250°C | 0 nm | 0 nm | 4 | 24 | 23 | 4 | 4 |
| Example 41 | 250°C | 0 nm | 0 nm | 4 | 23 | 22 | 4 | 4 |
| Example 42 | 250°C | 0 nm | 0 nm | 4 | 25 | 23 | 4 | 4 |
| Example 43 | 250°C | 0 nm | 0 nm | 4 | 24 | 22 | 4 | 4 |
| Comparative Example 1 | 250°C | 0 nm | 0 nm | 4 | 10 | 6 | 2 | 4 |
| Comparative Example 2 | 250°C | 0 nm | 0 nm | 2 | 12 | 7 | 4 | 2 |
| Comparative Example 3 | 250°C | 0 nm | 0 nm | 4 | 8 | 4 | 4 | 2 |

**[Table 4-1]**

| | Laminate production process | | | | | | | |
|---|---|---|---|---|---|---|---|---|
| | Laminate configuration | Planarization Step | | Activation step | | Bonding step | | |
| | | First substrate | Second substrate | First substrate | Second substrate | Pressure | Temperature (Head) | Temperature (Stage) |
| Example 19 | C2W | CMP | CMP | He plasma | He plasma | 8 MPa | 23°C | 23°C |
| Example 20 | C2W | CMP | CMP | He plasma | He plasma | 8 MPa | 23°C | 23°C |
| Example 21 | C2W | CMP | CMP | He plasma | He plasma | 8 MPa | 23°C | 23°C |
| Example 22 | C2W | CMP | CMP | He plasma | He plasma | 8 MPa | 23°C | 23°C |
| Example 23 | C2W | CMP | CMP | He plasma | He plasma | 8 MPa | 23°C | 23°C |
| Example 24 | C2W | CMP | CMP | He plasma | He plasma | 8 MPa | 23°C | 23°C |
| Example 25 | C2W | CMP | CMP | He plasma | He plasma | 8 MPa | 23°C | 23°C |
| Example 26 | C2W | CMP | CMP | He plasma | He plasma | 8 MPa | 23°C | 23°C |
| Example 27 | C2W | CMP | CMP | He plasma | He plasma | 8 MPa | 23°C | 23°C |
| Example 28 | C2W | CMP | CMP | He plasma | He plasma | 8 MPa | 23°C | 23°C |
| Example 29 | C2W | CMP | CMP | He plasma | He plasma | 8 MPa | 23°C | 23°C |
| Example 30 | C2W | Surface planer | Surface planer | He plasma | He plasma | 8 MPa | 23°C | 23°C |
| Example 31 | C2W | Surface planer | CMP | He plasma | He plasma | 8 MPa | 23°C | 23°C |
| Example 32 | C2W | CMP | CMP | Ar plasma | Ar plasma | 8 MPa | 23°C | 23°C |

**[Table 4-2]**

| | Laminate production process | | | | | | | |
|---|---|---|---|---|---|---|---|---|
| | Laminate configuration | Planarization Step | | Activation step | | Bonding step | | |
| | | First substrate | Second substrate | First substrate | Second substrate | Pressure | Temperature (Head) | Temperature (Stage) |
| Example 33 | C2W | CMP | CMP | He plasma | He plasma | 8 MPa | 23°C | 23°C |
| Example 34 | C2W | CMP | CMP | He plasma | He plasma | 8 MPa | 23°C | 23°C |
| Example 35 | C2W | CMP | CMP | He plasma | He plasma | 8 MPa | 100°C | 100°C |
| Example 36 | C2W | CMP | CMP | He plasma | He plasma | 8 MPa | 23°C | 23°C |
| Example 44 | W2W | CMP | CMP | He plasma | He plasma | 8 MPa | 23°C | 23°C |
| Example 45 | W2W | CMP | CMP | He plasma | He plasma | 8 MPa | 23°C | 23°C |
| Example 46 | W2W | CMP | CMP | He plasma | He plasma | 8 MPa | 23°C | 23°C |
| Example 47 | W2W | CMP | CMP | He plasma | He plasma | 8 MPa | 23°C | 23°C |
| Example 48 | W2W | CMP | CMP | He plasma | He plasma | 8 MPa | 23°C | 23°C |
| Example 49 | W2W | CMP | CMP | He plasma | He plasma | 8 MPa | 23°C | 23°C |
| Example 50 | W2W | CMP | CMP | He plasma | He plasma | 8 MPa | 23°C | 23°C |
| Comparative Example 4 | C2W | CMP | CMP | He plasma | He plasma | 8 MPa | 23°C | 23°C |
| Comparative Example 5 | C2W | CMP | CMP | He plasma | He plasma | 8 MPa | 23°C | 23°C |
| Comparative Example 6 | C2W | CMP | CMP | He plasma | He plasma | 8 MPa | 23°C | 23°C |

**[Table 4-3]**

| | Laminate production process | | | Evaluation results of laminate | | | | |
|---|---|---|---|---|---|---|---|---|
| | Anneal | Electrode-resin layer step | | Void area | Adhesive force (MPa) | | Reliability test | |
| | Temperature | First substrate | Second substrate | | After annealing | After PCT | HTS | TC |
| Example 19 | 250°C | 0 nm | 0 nm | 4 | 25 | 22 | 3 | 4 |
| Example 20 | 250°C | 0 nm | 0 nm | 4 | 25 | 22 | 2 | 4 |
| Example 21 | 250°C | 0 nm | 0 nm | 4 | 15 | 12 | 3 | 3 |
| Example 22 | 250°C | 0 nm | 0 nm | 3 | 15 | 12 | 3 | 3 |
| Example 23 | 250°C | 0 nm | 0 nm | 3 | 25 | 21 | 3 | 4 |
| Example 24 | 250°C | 0 nm | 0 nm | 4 | 25 | 21 | 3 | 4 |
| Example 25 | 250°C | 0 nm | 0 nm | 4 | 30 | 25 | 3 | 4 |
| Example 26 | 250°C | 0 nm | 0 nm | 4 | 30 | 27 | 4 | 4 |
| Example 27 | 250°C | 0 nm | 0 nm | 4 | 33 | 31 | 4 | 4 |
| Example 28 | 250°C | 0 nm | 0 nm | 4 | 35 | 33 | 4 | 4 |
| Example 29 | 250°C | 0 nm | 0 nm | 4 | 20 | 18 | 4 | 4 |
| Example 30 | 250°C | 0 nm | 0 nm | 4 | 15 | 12 | 4 | 4 |
| Example 31 | 250°C | 0 nm | 0 nm | 4 | 17 | 14 | 4 | 4 |
| Example 32 | 250°C | 0 nm | 0 nm | 4 | 25 | 21 | 4 | 4 |

**[Table 4-4]**

| | Laminate production process | | | Evaluation results of laminate | | | | |
|---|---|---|---|---|---|---|---|---|
| | Anneal | Electrode-resin layer step | | Void area | Adhesive force (MPa) | | Reliability test | |
| | Temperature | First substrate | Second substrate | | After annealing | After PCT | HTS | TC |
| Example 33 | 250°C | 5 nm | 0 nm | 4 | 37 | 34 | 4 | 4 |
| Example 34 | 250°C | 5 nm | 5 nm | 4 | 39 | 35 | 4 | 4 |
| Example 35 | 250°C | 0 nm | 0 nm | 4 | 25 | 21 | 3 | 3 |
| Example 36 | 300°C | 0 nm | 0 nm | 4 | 25 | 21 | 4 | 4 |
| Example 44 | 250°C | 0 nm | 0 nm | 4 | 34 | 30 | 4 | 4 |
| Example 45 | 250°C | 5 nm | 0 nm | 4 | 36 | 31 | 4 | 4 |
| Example 46 | 250°C | 0 nm | 0 nm | 4 | 22 | 19 | 4 | 4 |
| Example 47 | 250°C | 0 nm | 0 nm | 4 | 24 | 23 | 4 | 4 |
| Example 48 | 250°C | 0 nm | 0 nm | 4 | 23 | 22 | 4 | 4 |
| Example 49 | 250°C | 0 nm | 0 nm | 4 | 25 | 23 | 4 | 4 |
| Example 50 | 250°C | 0 nm | 0 nm | 4 | 24 | 22 | 4 | 4 |
| Comparative Example 4 | 250°C | 0 nm | 0 nm | 2 | 10 | 6 | 2 | 4 |
| Comparative Example 5 | 250°C | 0 nm | 0 nm | 2 | 12 | 7 | 4 | 2 |
| Comparative Example 6 | 250°C | 0 nm | 0 nm | 1 | 8 | 4 | 4 | 2 |

**[Table 5]**

| | Resin composition | Resin | CTE ppm/K | |
|---|---|---|---|---|
| | | | | Determination |
| Adjustment Example 12 | V-12 | P-8 | 34 | B |
| Adjustment Example 13 | V-13 | P-9 | 20 | A |
| Adjustment Example 14 | V-14 | P-10 | 23 | A |
| Adjustment Example 15 | V-15 | P-11 | 21 | A |
| Comparative Adjustment Example 2 | HV-2 | HP-2 | 4 | C |

### DESCRIPTION OF REFERENCE SIGNS

- 1:: Substrate body (silicon wafer or the like)
- 2:: (A-1) Metal electrode (Cu or the like)
- 3:: (B-1) Resin layer
- 4:: (B-2) Resin layer or (C) inorganic insulating layer
- 5:: (A-2) Metal electrode (Cu or the like)
- 6:: Substrate body (silicon wafer or the like)
- 7:: First substrate
- 8:: Second substrate

## Claims

1. A method for producing a laminate, the method comprising:
step (I) of preparing a first substrate including an exposed (A-1) metal electrode and an exposed (B-1) resin layer provided on the same face of a substrate body;
step (II) of preparing a second substrate including an exposed (A-2) metal electrode and an exposed (B-2) resin layer, or an exposed (A-2) metal electrode and an exposed (C) inorganic insulating layer provided on the same face of a substrate body; and
step (III) of laminating the first substrate and the second substrate together by direct bonding,
while making at least a part of the (A-1) metal electrode face the (A-2) metal electrode and making at least a part of the (B-1) resin layer face the (B-2) resin layer, or alternatively
while making at least a part of the (A-1) metal electrode face the (A-2) metal electrode and making at least a part of the (B-1) resin layer face the (C) inorganic insulating layer,
wherein at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by formula (1) or formula (2), 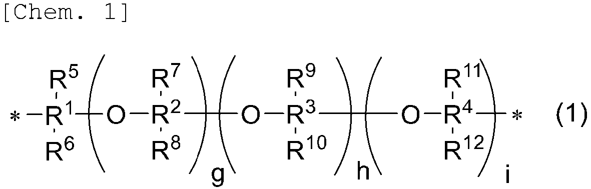
in the formula (1), R¹ to R⁴ each independently represent an alkylene group having 1 to 6 carbon atoms; R⁵ to R¹² each independently represent a hydrogen atom, a fluorine atom, or an alkyl group having 1 to 6 carbon atoms; parenthesized structures are different from each other; g, h, and i each independently represent an integer of 0 to 35, and g + h + i > 0; symbol * represents a bonding site, 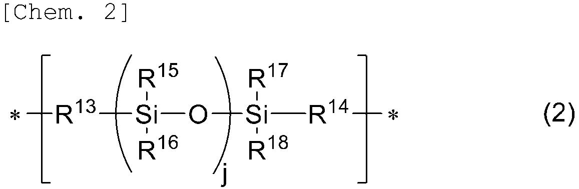
in the formula (2), j is a natural number of 1 to 50; R¹³ and R¹⁴ each independently represent an alkylene group having 1 to 30 carbon atoms, an alkenylene group having 2 to 10 carbon atoms, an alkynylene group having 2 to 10 carbon atoms, or a phenylene group having 6 to 20 carbon atoms; R¹⁵ to R¹⁸ each independently represent an alkyl group having 1 to 30 carbon atoms, a phenyl group, or a phenoxy group; symbol * represents a bonding site.

2. The method for producing a laminate according to claim 1, wherein the second substrate includes the exposed (A-2) metal electrode and the exposed (B-2) resin layer provided on the same face of a substrate body.

3. The method for producing a laminate according to claim 1 or 2, wherein at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1).

4. The method for producing a laminate according to claim 1 or 2, wherein at least one of the (B-1) resin layer and the (B-2) resin layer contains two or more structures represented by formula (9): 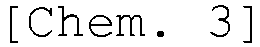 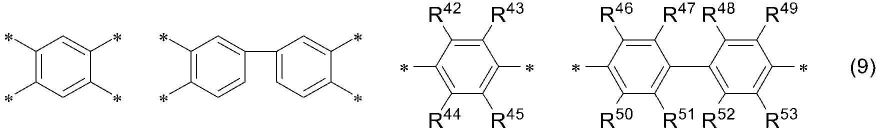 wherein symbol * represents a bonding site; R⁴² to R⁵³ each independently represent a hydrogen atom, a fluorine atom, a hydroxy group, or a hydrocarbon group having 1 to 6 carbon atoms, which may be partially or fully substituted with one or more among a fluorine atom, a hydroxy group, and a carboxyl group.

5. The method for producing a laminate according to claim 1 or 2, wherein at least one of the (B-1) resin layer and the (B-2) resin layer further contains an antioxidant.

6. The method for producing a laminate according to claim 1 or 2, wherein at least one of the (B-1) resin layer and the (B-2) resin layer forms a crosslinked structure.

7. The method for producing a laminate according to claim 1 or 2, wherein at least one of the (B-1) resin layer and the (B-2) resin layer has an elastic modulus of 1.5 GPa or more and 7.0 GPa or less.

8. The method for producing a laminate according to claim 1 or 2, wherein a coefficient of thermal expansion of at least one of the (B-1) resin layer and the (B-2) resin layer in a temperature range of 50°C to 150°C is 10 ppm/K or more and 40 ppm/K or less.

9. The method for producing a laminate according to claim 1 or 2, wherein at least one of the step (I) and the step (II) includes a smoothing step by at least one of chemical mechanical polishing and a surface planer.

10. The method for producing a laminate according to claim 2, wherein at least one of a step between the (A-1) metal electrode and the (B-1) resin layer of the first substrate after the step (I) and a step between the (A-2) metal electrode and the (B-2) resin layer of the second substrate after the step (II) is 1 nm or more and 20 nm or less, and the resin layer is lower than the metal electrode.

11. The method for producing a laminate according to claim 10, wherein a step between the (A-1) metal electrode and the (B-1) resin layer of the first substrate after the step (I) is 1 nm or more and 20 nm or less, and the resin layer is lower than the metal electrode.

12. The method for producing a laminate according to claim 1 or 2, wherein the step (I) includes a singulation step, and in the step (III), a plurality of singulated pieces of the first substrate and a single piece of the second substrate are laminated to each other.

13. The method for producing a laminate according to claim 1 or 2, wherein in the step (III), at the time of laminating the first substrate and the second substrate, a temperature of a lamination stage and a temperature of a bonding head are 20°C or more and 50°C or less.

14. The method for producing a laminate according to claim 1 or 2, wherein a surface of each of the first substrate and the second substrate on a side to be laminated is subjected to plasma treatment as pretreatment of the step (III).

15. The method for producing a laminate according to claim 14, wherein the plasma treatment is performed under an atmosphere of inert gas.

16. The method for producing a laminate according to claim 15, at least helium is contained as the inert gas.

17. The method for producing a laminate according to claim 1 or 2, further comprising a step of performing annealing treatment at 150°C or more and 250°C or less after the step (III).

18. The method for producing a laminate according to claim 1 or 2, wherein at least one of the (B-1) resin layer and the (B-2) resin layer is formed by curing, at 170°C or more and 250°C or less, a resin composition comprising one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by formula (1) or formula (2), and a solvent, 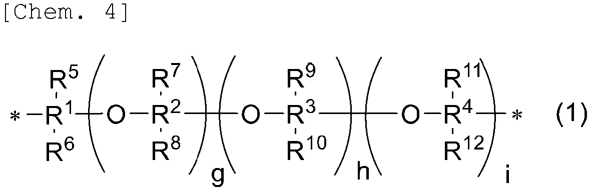 in the formula (1), R¹ to R⁴ each independently represent an alkylene group having 1 to 6 carbon atoms; R⁵ to R¹² each independently represent a hydrogen atom, a fluorine atom, or an alkyl group having 1 to 6 carbon atoms; parenthesized structures are different from each other; g, h, and i each independently represent an integer of 0 to 35, and g + h + i > 0; symbol * represents a bonding site; 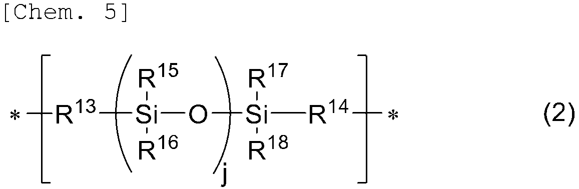 in the formula (2), j is a natural number of 1 to 50; R¹³ and R¹⁴ may be the same or different and each represent an alkylene group having 1 to 30 carbon atoms, an alkenylene group, an alkynylene group, or a phenylene group; R¹⁵ to R¹⁸ may be the same or different and each represent an alkyl group having 1 to 30 carbon atoms, a phenyl group, or a phenoxy group; symbol * represents a bonding site.

19. A resin composition comprising a resin which has a group represented by the following formula (1) or the following formula (2) and which contains one or more among polyimides, polyimide precursors, polybenzoxazoles, polybenzoxazole precursors, polyamides excluding the polyimide precursors and the polybenzoxazole precursors, and copolymers thereof, and a solvent,
the resin composition being to be used for at least one resin layer of a (B-1) resin layer and a (B-2) resin layer in a method for producing a laminate including at least the following steps (I), (II) and (III):
step (I): preparing a first substrate including an exposed (A-1) metal electrode and an exposed (B-1) resin layer provided on the same face of a substrate body;
step (II): preparing a second substrate including an exposed (A-2) metal electrode and an exposed (B-2) resin layer, or an exposed (A-2) metal electrode and an exposed (C) inorganic insulating layer provided on the same face of a substrate body;
step (III): laminating the first substrate and the second substrate together by direct bonding while making at least a part of the (A-1) metal electrode and the (A-2) metal electrode face each other and making at least a part of the (B-1) resin layer and the (B-2) resin layer face each other, or alternatively making at least a part of the (A-1) metal electrode and the (A-2) metal electrode face each other and making at least a part of the (B-1) resin layer and the (C) inorganic insulating layer face each other, 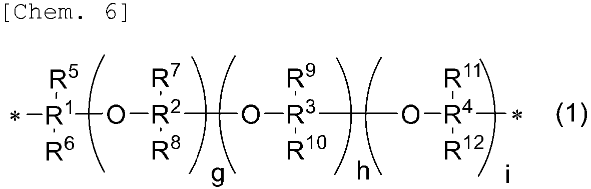
in the formula (1), R¹ to R⁴ each independently represent an alkylene group having 1 to 6 carbon atoms; R⁵ to R¹² each independently represent a hydrogen atom, a fluorine atom, or an alkyl group having 1 to 6 carbon atoms; parenthesized structures are different from each other; g, h, and i each independently represent an integer of 0 to 35, and g + h + i > 0; symbol * represents a bonding site; 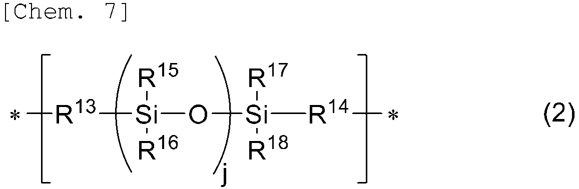
in the formula (2), j is a natural number of 1 to 50; R¹³ and R¹⁴ may be the same or different and each represent an alkylene group having 1 to 30 carbon atoms, an alkenylene group, an alkynylene group, or a phenylene group; R¹⁵ to R¹⁸ may be the same or different and each represent an alkyl group having 1 to 30 carbon atoms, a phenyl group, or a phenoxy group; symbol * represents a bonding site.

20. The resin composition according to claim 19, wherein the step (III) is a step of laminating the first substrate and the second substrate together by direct bonding while making at least a part of the (A-1) metal electrode and the (A-2) metal electrode face each other and making at least a part of the (B-1) resin layer and the (B-2) resin layer face each other.

21. The resin composition according to claim 19 or 20, comprising a resin which has a group represented by the formula (1) or the formula (2), contains two or more structures represented by formula (9), and contains one or more among polyimides, polyimide precursors, polybenzoxazoles, polybenzoxazole precursors, polyamides excluding the polyimide precursors and the polybenzoxazole precursors, and copolymers thereof, and a solvent, 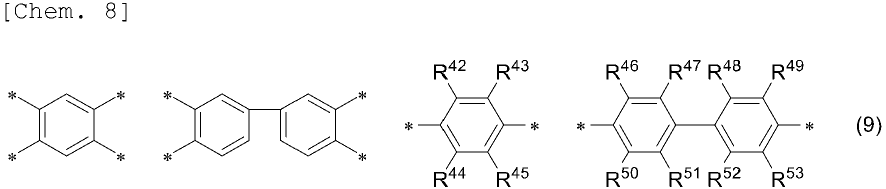 wherein symbol * represents a bonding site; R⁴² to R⁵³ each independently represent a hydrogen atom, a fluorine atom, a hydroxy group, or a hydrocarbon group having 1 to 6 carbon atoms, which may be partially or fully substituted with one or more among a fluorine atom, a hydroxy group, and a carboxyl group.

22. The resin composition according to claim 19 or 20, further comprising an antioxidant.

23. The resin composition according to claim 19 or 20, further comprising a photoacid generator.

24. The resin composition according to claim 19 or 20, further comprising a crosslinking agent.
